# EUROPEAN PATENT APPLICATION

(11) **EP 4 525 592 A1**
(43) Date of publication of application: **19.03.2025**
(21) Application number: 24199085.2
(22) Date of filing: 06.09.2024
(51) Int. Cl.: H10K 59/80, H10K 77/00, H10K 77/10, H10K 102/00

(54) **DISPLAY DEVICE AND METHOD OF FABRICATING THE SAME**

(30) Priority: 12.09.2023 KR 20230121088
(71) Applicant: Samsung Display Co., Ltd., Gyeonggi-do 17113 (KR)
(72) Inventor: KWON, Oh June, Yongin-si (KR); SUNG, Woo Yong, Yongin-si (KR); SONG, Seung Yong, Yongin-si (KR)
(74) Representative: Marks & Clerk LLP

(57) **Abstract**

A display device includes: a substrate including a flat portion and a bending portion disposed on a side of the flat portion; a light emitting element layer disposed on the substrate and including light emitting elements disposed in the flat portion and the bending portion; and an encapsulation layer disposed over the flat portion and the bending portion and including a first inorganic encapsulation layer disposed on the light emitting element layer, an organic encapsulation layer disposed on the first inorganic encapsulation layer, and a second inorganic encapsulation layer disposed on the organic encapsulation layer. At least a portion of the organic encapsulation layer disposed in the bending portion includes a portion protruding in a direction upward from the substrate, and a maximum height of the organic encapsulation layer disposed in the bending portion is greater than a maximum height of the organic encapsulation layer disposed in the flat portion.

## Description

### BACKGROUND

### 1. Field

The disclosure relates to a display device and a method of fabricating the same.

### 2. Description of the Related Art

As the information society develops, demands for display devices for displaying images are increasing in various forms. For example, display devices are applied to various electronic devices such as smartphones, digital cameras, notebook computers, navigation devices, and smart televisions. The display devices may be flat panel display devices such as liquid crystal display devices, field emission display devices, and organic light emitting display devices. Among these flat panel display devices, a light emitting display device includes a light emitting element that enables each pixel of a display panel to emit light by itself. Thus, the light emitting display device can display an image without a backlight unit that provides light to the display panel.

A display device may further include pixels that emit predetermined light, scan lines, data lines and power lines for driving the pixels, a scan driver that outputs scan signals to the scan lines, and a display driver that outputs data voltages to the data lines.

### SUMMARY

Aspects of the disclosure provide a display device which can relieve stress applied when bent or folded.

However, aspects of the disclosure are not restricted to the one set forth herein. The above and other aspects of the disclosure will become more apparent to one of ordinary skill in the art to which the disclosure pertains by referencing the detailed description of the disclosure given below.

According to an embodiment of the disclosure, a display device includes: a substrate including a flat portion and a bending portion disposed on a side of the flat portion, a light emitting element layer disposed on the substrate and including a plurality of light emitting elements disposed in the flat portion and the bending portion, and an encapsulation layer disposed over the flat portion and the bending portion and including a first inorganic encapsulation layer disposed on the light emitting element layer, an organic encapsulation layer disposed on the first inorganic encapsulation layer, and a second inorganic encapsulation layer disposed on the organic encapsulation layer, where at least a portion of the organic encapsulation layer disposed in the bending portion includes a portion protruding in a direction upward from the substrate, and a maximum height of the organic encapsulation layer disposed in the bending portion is greater than a maximum height of the organic encapsulation layer disposed in the flat portion.

An average height of the organic encapsulation layer disposed in the bending portion may be greater than an average height of the organic encapsulation layer disposed in the flat portion.

The organic encapsulation layer may include an organic insulating material, and the volume of the organic insulating material per unit area of the protruding portion of the bending portion may be larger than the volume of the organic insulating material per unit area of the flat portion.

A surface length of the second inorganic encapsulation layer measured in a unit area of the bending portion may be greater than a surface length of the second inorganic encapsulation layer measured in a unit area of the flat portion.

The first inorganic encapsulation layer may include a first area and a second area other than the first area disposed in the bending portion, the first area may have lower surface energy than the second area, and a height of the organic encapsulation layer disposed in the first area may be greater than a height of the organic encapsulation layer disposed in the second area.

The display device may further include a pattern portion disposed on the first inorganic encapsulation layer in the bending portion and including a material having higher surface energy than a material surrounding the pattern portion, and the organic encapsulation layer may have a greater height in a portion overlapping the pattern portion than in other areas of the bending portion.

The protruding portion may be provided in plurality in the organic encapsulation layer disposed in the bending portion.

The bending portion may be bent toward a rear surface of the substrate opposite a surface of the substrate on which the light emitting element layer is disposed.

The bending portion may include a first bending portion disposed on a side of the flat portion in a first direction and a second bending portion disposed on the other side of the flat portion in a direction opposite to in the first direction, and the first bending portion, the second bending portion and the flat portion have the same length measured in a second direction.

The protruding portion of the organic encapsulation layer may be disposed to correspond to a curved area of the bending portion.

According to an embodiment of the disclosure, a display device includes a substrate including a folding area folded along a folding line extending in a first direction and a non-folding area disposed around the folding area, a light emitting element layer disposed on the substrate and including a plurality of light emitting elements disposed in the folding area and the non-folding area, and an encapsulation layer disposed over the folding area and the non-folding area and including a first inorganic encapsulation layer disposed on the light emitting element layer, an organic encapsulation layer disposed on the first inorganic encapsulation layer and including an organic insulating material, and a second inorganic encapsulation layer disposed on the organic encapsulation layer, where at least a portion of the organic encapsulation layer disposed in the folding area includes a portion protruding in a direction upward from the substrate, and the volume of the organic insulating material of the organic encapsulation layer per unit area of the folding area is larger than the volume of the organic insulating material per unit area of the non-folding area.

A surface length of the second inorganic encapsulation layer measured in a unit area of the folding area may be greater than a surface length of the second inorganic encapsulation layer measured in a unit area of the non-folding area.

A maximum height of the organic encapsulation layer disposed in the folding area may be greater than a maximum height of the organic encapsulation layer disposed in the non-folding area.

According to an embodiment of the disclosure, a method of fabricating a display device includes forming a light emitting element layer, which includes a plurality of light emitting elements, on a substrate including a flat portion and a bending portion disposed on a side of the flat portion, forming a first inorganic encapsulation layer on the light emitting element layer and forming an organic encapsulation layer by applying an organic insulating material on the first inorganic encapsulation layer, and forming a second inorganic encapsulation layer on the organic encapsulation layer, where in the forming of the organic encapsulation layer, the amount of the organic insulating material applied per unit area of the bending portion is larger than the amount of the organic insulating material applied per unit area of the flat portion.

The method may further include, before the forming of the organic encapsulation layer, forming a first area with lower surface energy than an adjacent area by surface-treating a portion of the first inorganic encapsulation layer disposed in the bending portion.

The method may further include, after the forming of the first inorganic encapsulation layer, forming a pattern portion disposed on the first inorganic encapsulation layer in the bending portion and including a material with higher surface energy than the organic insulating material surrounding thereof.

In the applying of the organic insulating material, the organic insulating material agglomerate around the pattern portion, and a portion of the organic encapsulation layer which overlaps the pattern portion may have a greater height than other portions.

The organic encapsulation layer may include an organic insulating material, and the volume of the organic insulating material per unit area of the bending portion may be larger than the volume of the organic insulating material per unit area of the flat portion.

A maximum height of the organic encapsulation layer disposed in the bending portion may be greater than a maximum height of the organic encapsulation layer disposed in the flat portion.

A surface length of the second inorganic encapsulation layer measured in a unit area of the bending portion may be greater than a surface length of the second inorganic encapsulation layer measured in a unit area of the flat portion.

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a perspective view of a display device according to an embodiment;
FIG. 2 is a plan view of the display device of FIG. 1;
FIG. 3 is a cross-sectional view taken along line A-A' of FIG. 2;
FIG. 4 is a cross-sectional view of the display device of FIG. 2, taken along a second direction;
FIG. 5 is a plan view of a display panel according to an embodiment;
FIG. 6 is a pixel circuit diagram of a subpixel according to an embodiment;
FIG. 7 is a pixel circuit diagram of a subpixel according to an embodiment;
FIG. 8 is a cross-sectional view of a subpixel of the display device according to the embodiment;
FIG. 9 is a cross-sectional view of an outer portion of the display device according to the embodiment;
FIG. 10 is a schematic cross-sectional view of an encapsulation layer in a flat portion and a bending portion of the display device in a flat state according to the embodiment;
FIG. 11 is a cross-sectional view illustrating the structure of an organic encapsulation layer of the encapsulation layer in the bending portion of FIG. 10 in detail;
FIG. 12 illustrates the bending portion of the display device of FIG. 10 in a bent state;
FIG. 13 is a schematic cross-sectional view of an encapsulation layer in a flat portion and a bending portion of a display device in a flat state according to an embodiment;
FIG. 14 illustrates the bending portion of the display device of FIG. 13 in a bent state;
FIG. 15 is a flowchart illustrating a method of fabricating a display device according to an embodiment;
FIGS. 16 through 19 are views sequentially illustrating a process of fabricating a display device according to an embodiment;
FIG. 20 is a perspective view of a foldable display device according to an embodiment;
FIG. 21 is a perspective view of the foldable display device of FIG. 20 in a folded state;
FIG. 22 is a schematic cross-sectional view of the foldable display device according to the embodiment of FIG. 20;
FIG. 23 is a cross-sectional view of the foldable display device of FIG. 22 in a folded state;
FIG. 24 is a cross-sectional view of an encapsulation layer of the foldable display device of FIG. 22 in a flat state; and
FIG. 25 is a cross-sectional view of the encapsulation layer of the foldable display device of FIG. 24 in a folded state.

### DETAILED DESCRIPTION

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof. Hereinafter, embodiments will be described with reference to the accompanying drawings.

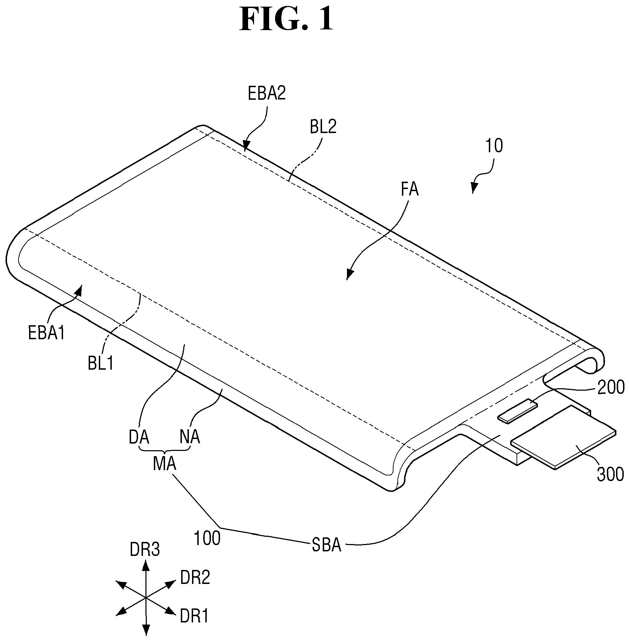

FIG. 1 is a perspective view of a display device 10 according to an embodiment.

Referring to FIG. 1, the display device 10 is a device for displaying moving images or still images. The display device 10 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards and Internet of things (IoT) devices.

The display device 10 may be a light emitting display device such as an organic light emitting display device including an organic light emitting diode, a quantum dot light emitting display device including a quantum dot light emitting layer, an inorganic light emitting display device including an inorganic semiconductor, or a micro- or nano-light emitting display device using a micro- or nano-light emitting diode. An embodiment in which the display device 10 is an organic light emitting display device will be described below, but the type of the display device is not limited thereto.

In an embodiment, the display device 10 may be formed flat in a center area. For example, the display device 10 may be formed substantially flat on a plane defined by a first direction DR1 and a second direction DR2 and may have a predetermined thickness in a third direction DR3.

In an embodiment, the first direction DR1 may be a lengthwise direction, a column direction or a vertical direction of an image display surface of the display device 10, and the second direction DR2 may be a direction intersecting the first direction DR1, for example, may be a widthwise direction, a row direction or a horizontal direction. The third direction DR3 may be a thickness direction of the display device 10.

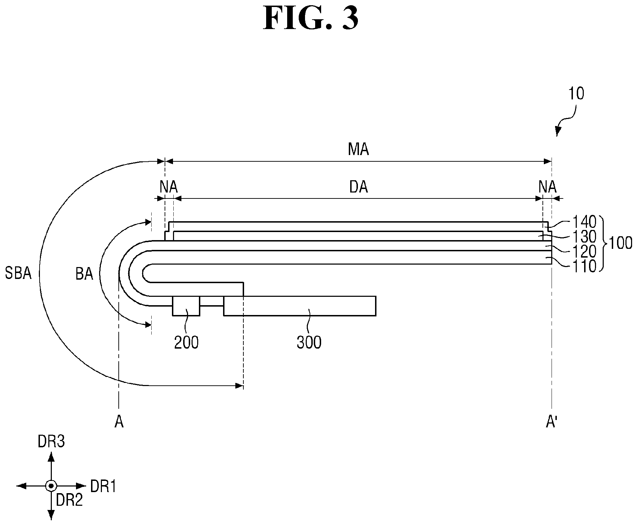

In an embodiment, the display device 10 may include a flat portion FA of the image display surface and, as edge areas, bending portions EBA1 and EBA2 that are bent with a predetermined curvature. The flat portion FA may be generally disposed in the center of the display device 10, and the bending portions EBA1 and EBA2 may be disposed on opposite sides of the flat portion FA in the second direction DR2. The flat portion FA may be located between a first bending line BL1 and a second bending line BL2, a first bending portion EBA1 may be located on a left side of the flat portion FA, and a second bending portion EBA2 may be located on a right side of the flat portion FA. The flat portion FA, the first bending portion EBA1, and the second bending portion EBA2 may have the same length in the first direction DR1, and a width of the flat portion FA in the second direction DR2 may be the largest. The display device 10 may have a shape in which opposite edges in the second direction DR2 are bent downward, i.e., toward one side in the third direction DR3. The display device 10 may be bent toward a lower surface of a substrate 110 (see FIG. 3) rather than toward an upper surface of the substrate 110.

In an embodiment, the bending portions EBA1 and EBA2, which are the edge areas of the display device 10, may be flat without being bent. Alternatively, the display device 10 may be formed to be flexible so that areas other than the edge areas can be curved, bent, folded, or rolled.

The display device 10 may include a display panel 100, a driver 200, and a circuit board 300.

The display panel 100 may include a main area MA including a display area DA where an image is displayed and a sub-area SBA located on a side of the main area MA.

The main area MA may include the display area DA and a non-display area NA around the display area DA. The display area DA may be located in the center of the main area MA and may occupy most of the main area MA. The non-display area NA may be located at edges of the main area MA and may contact the sub-area SBA. The main area MA may include the flat portion FA and the bending portions EBA1 and EBA2 of the display device 10.

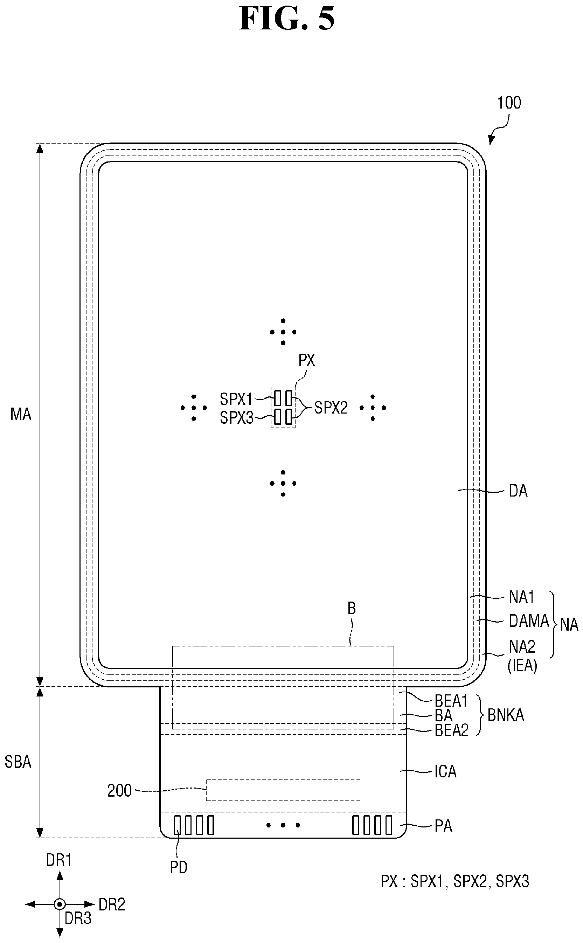

The display area DA may be an area where pixels (e.g., pixels PX of FIG. 5) are arranged and where an image is displayed by the pixels PX. In an embodiment, sensing patterns (e.g., touch electrodes) for detecting a touch input or the like may be further provided in the display area DA, and the display area DA may include a sensing area where a touch input is detected by the sensing patterns.

In an embodiment, the display area DA may be shaped like a substantially rectangular plane having long sides in the first direction DR1 and short sides in the second direction DR2. Each corner where a long side and a short side of the display area DA meet may be rounded or right-angled. The shape of the display area DA may vary according to embodiments. For example, the display area DA may also have a polygonal shape other than a quadrilateral shape, a circular shape, or an oval shape.

The display area DA may include the flat portion FA and some areas of the bending portions EBA1 and EBA2 of the display device 10. The display device 10 may display a screen in the flat portion FA and some areas of the bending portions EBA1 and EBA2.

The non-display area NA may be located immediately around the display area DA. The non-display area NA may surround the display area DA. An embedded circuit may be disposed in the non-display area NA. In an embodiment, for example, an embedded circuit such as a scan driving circuit may be disposed in the non-display area NA on one side (e.g., a left or right side) or opposite sides of the display area DA.

The sub-area SBA may be located on a side of the main area MA. In an embodiment, for example, the sub-area SBA may be an area protruding from a side of the main area MA in the first direction DR1. In an embodiment, for example, the sub-area SBA may protrude from a lower end of the main area MA in the first direction DR1. In an embodiment, the sub-area SBA may be narrower than the main area MA. In an embodiment, for example, the sub-area SBA may be narrower than the main area MA in the second direction DR2.

Lines and pads may be disposed in the sub-area SBA. For example, lines and pads connected to pixels and/or an embedded circuit located in the main area MA and the driver 200 and/or the circuit board 300 located in the sub-area SBA may be disposed in the sub-area SBA. In the description of embodiments, the term "connection" may mean electrical connection and/or physical connection.

In an embodiment, the driver 200 (e.g., a display driving circuit) may be mounted in the sub-area SBA. The circuit board 300 may be disposed on a portion of the sub-area SBA.

The driver 200 may include a data driving circuit for driving pixels. In an embodiment, the driver 200 may be formed as an integrated circuit (IC) chip and disposed in the sub-area SBA. In an embodiment, the driver 200 may be disposed on the circuit board 300 in the sub-area SBA or may be disposed on another circuit board connected to the display panel 100 through the circuit board 300.

The circuit board 300 may be disposed on a portion of the sub-area SBA. In an embodiment, for example, the circuit board 300 may be bonded onto pads located in a portion (e.g., a lower edge) of the sub-area SBA and may supply or transmit power voltages and driving signals for driving the display panel 100 to the display panel 100. In an embodiment, for example, the circuit board 300 may supply input image data (e.g., digital image data), driving signals including timing signals, and driving voltages to the display panel 100. The circuit board 300 may be, but is not limited to, a flexible printed circuit board (FPCB), a printed circuit board (PCB), or a flexible film such as a chip on film (COF).

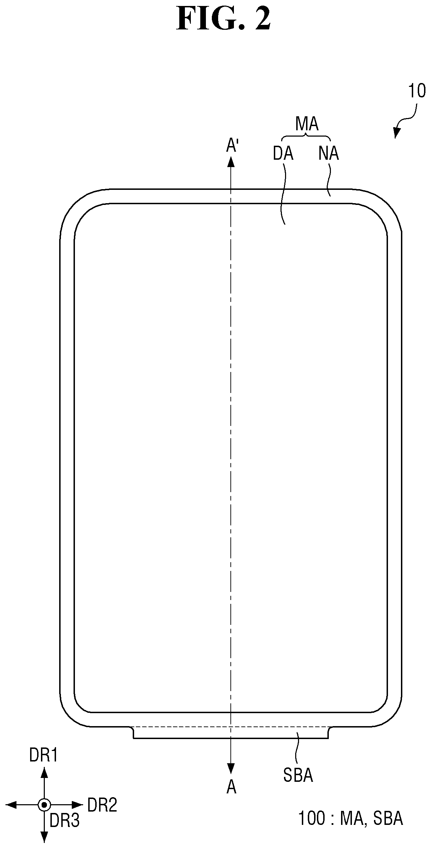

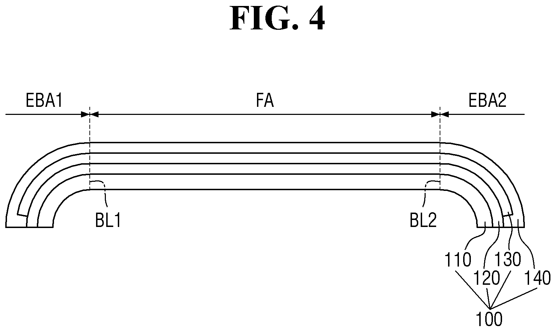

FIG. 2 is a plan view of the display device 10 of FIG. 1. FIG. 3 is a cross-sectional view taken along line A-A' of FIG. 2. FIG. 4 is a cross-sectional view of the display device 10 of FIG. 2, taken along the second direction DR2.

FIG. 1 illustrates a state in which the display device 10 is unfolded without being bent, and FIGS. 2 and 3 illustrate a state in which a bending area BA the display device 10 is bent in the sub-area SBA. FIG. 1 illustrates a state in which the sub-area SBA is unfolded to lie side by side with the main area MA, and FIGS. 2 and 3 illustrate a state in which a portion of the sub-area SBA is bent. FIG. 4 illustrates cross-sectional shapes of the flat portion FA and the bending portions EBA1 and EBA2 of the display device 10.

Referring to FIGS. 2 through 4, the display panel 100 may include the substrate 110 including the main area MA and the sub-area SBA and a circuit layer 120, a light emitting element layer 130 and an encapsulation layer 140 sequentially disposed on the substrate 110. The circuit layer 120 may be located on the substrate 110 in the main area MA and the sub-area SBA. The light emitting element layer 130 and the encapsulation layer 140 may be located on a portion of the substrate 110 and the circuit layer 120. In an embodiment, for example, the light emitting element layer 130 and the encapsulation layer 140 may be located in the main area MA.

In an embodiment, the display device 10 may further include an additional element disposed on the display panel 100. In an embodiment, for example, the display device 10 may further include at least one of a sensor layer (e.g., a touch sensor layer), a polarizing layer, a color filter layer, and a protective layer (e.g., a window) disposed on the encapsulation layer 140. Each of the sensor layer, the polarizing layer, the color filter layer, and/or the protective layer may be manufactured integrally with the display panel 100 or may be manufactured separately from the display panel 100 and then attached to the display panel 100 by an adhesive layer or the like.

The substrate 110 may include an insulating material such as polymer resin. In an embodiment, for example, the substrate 110 may be made of polyimide or other insulating materials. The substrate 110 may be a flexible substrate that can be bent, folded, or rolled. Alternatively, the substrate 110 may include an insulating material such as glass.

The circuit layer 120 may include pixel circuits and lines. In an embodiment, for example, the circuit layer 120 may include circuit elements (e.g., pixel transistors and a capacitor) constituting a pixel circuit of each pixel and lines connected to the pixels. In an embodiment, the circuit layer 120 may further include circuit elements constituting an embedded circuit, such as a scan driving circuit, and lines connected to the embedded circuit.

The light emitting element layer 130 may include light emitting elements disposed in emission areas of pixels. In an embodiment, for example, each of the pixels may include at least one light emitting element and a pixel circuit connected to the light emitting element. Each of the pixels may be located in a pixel area including an emission area where a light emitting element is disposed and a pixel circuit area where a pixel circuit is disposed. The emission area and pixel circuit area of each pixel may overlap each other in a normal direction of the substrate 110, but the disclosure is not limited thereto.

In the description of embodiments, the circuit layer 120 and the light emitting element layer 130 are described as being separate from each other. However, the embodiments are not limited thereto. For another example, the circuit layer 120 and the light emitting element layer 130 may also be integrated.

The encapsulation layer 140 may cover the light emitting element layer 130 and extend to the non-display area NA to contact the circuit layer 120. In an embodiment, the encapsulation layer 140 may have a multilayer structure including at least two inorganic encapsulation layers overlapping each other in a normal direction of the substrate 110 and at least one organic encapsulation layer interposed between the inorganic encapsulation layers.

In an embodiment, the display panel 100 may be bent in the bending area BA. The bending area BA may be a portion of the sub-area SBA and may be spaced apart from the main area MA.

The substrate 110 and the circuit layer 120 may be bent in the bending area BA corresponding to a portion of the sub-area SBA. Accordingly, a bezel area perceived by a user as the non-display area NA can be reduced or minimized.

In the display device 10, the substrate 110 may be a flexible substrate that can be bent, folded or rolled, and the bending portions EBA1 and EBA2 located on opposite sides in the second direction DR2 may be bent downward, i.e., toward one side in the third direction DR3. The bending portions EBA1 and EBA2 may be bent toward the lower surface of the substrate 110 opposite the upper surface of the substrate 110 on which the light emitting element layer 130 is disposed. A portion of the light emitting element layer 130 that emits light in the display device 10 may also be disposed in the bending portions EBA1 and EBA2 and may be bent downward, i.e., toward one side in the third direction DR3. Accordingly, light may also be emitted from some areas of the bending portions EBA1 and EBA2 of the display device 10.

FIG. 5 is a plan view of a display panel 100 according to an embodiment. FIG. 5 illustrates the display panel 100 in an unfolded state without being bent in the bending area BA.

Referring to FIG. 5, the display panel 100 may include the main area MA and the sub-area SBA. The main area MA may include the display area DA and the non-display area NA, and the sub-area SBA may include a bank area BNKA, a driving circuit mounting area ICA and a pad area PA.

The display area DA may be an area where a plurality of pixels PX are disposed. The pixels PX and lines (or portions of the lines) connected to the pixels PX may be disposed in the display area DA.

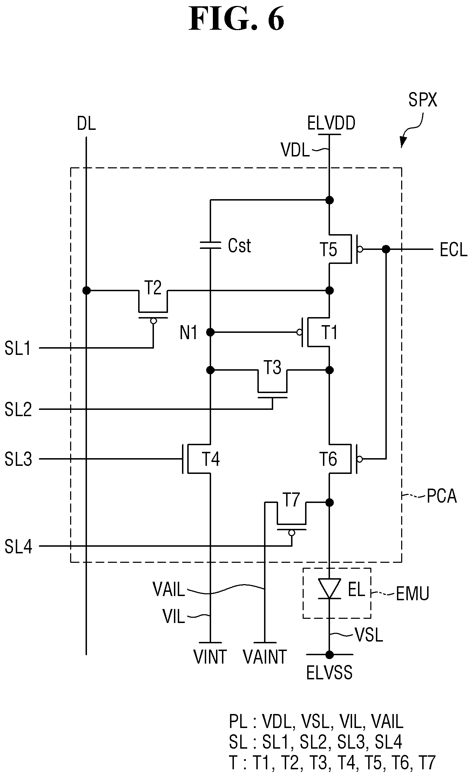

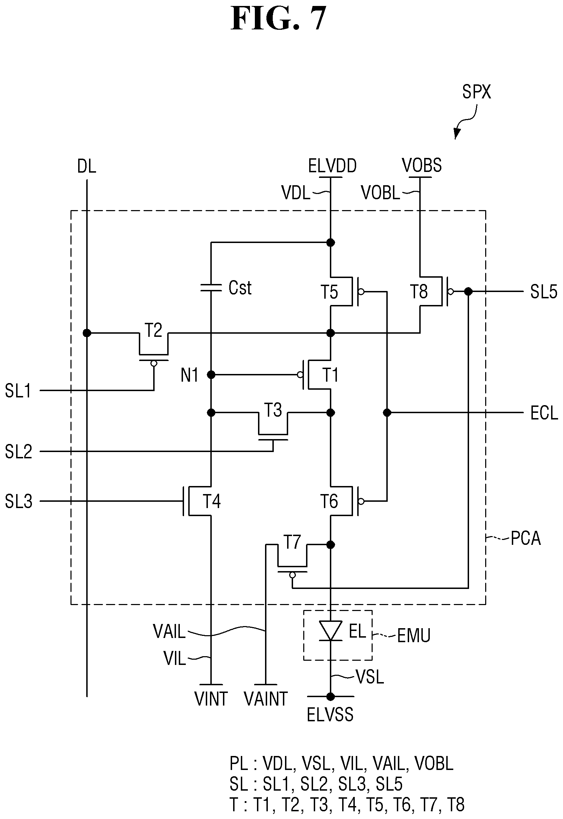

The pixels PX may be provided in the circuit layer 120 and the light emitting element layer 130 of the display panel 100. In an embodiment, for example, each of the pixels PX may include a pixel circuit (e.g., a pixel circuit PCA of FIG. 6 or 7) including circuit elements disposed in the circuit layer 120 and a light emitting element (e.g., a light emitting element EL of FIG. 6 or 7) disposed in the light emitting element layer 130.

The pixels PX may include at least two-color subpixels SPX emitting light of different colors. In an embodiment, for example, the pixels PX may include first-color subpixels SPX1 emitting light of a first color (e.g., red light), second-color subpixels SPX2 emitting light of a second color (e.g., green light), and third-color subpixels SPX3 emitting light of a third color (e.g., blue light).

At least one first-color subpixel SPX1, at least one second-color subpixel SPX2, and at least one third-color subpixel SPX3 adjacent to each other may form one unit pixel PX. In an embodiment, for example, one first-color subpixel SPX1, two second-color subpixels SPX2, and one third-color subpixel SPX3 adjacent to each other may form one unit pixel PX. Each unit pixel PX may emit light of various colors including white light by mixing the colors of light emitted from the subpixels SPX1 through SPX3 that form the unit pixel PX. In an embodiment, the first-color subpixels SPX1 and the third-color subpixels SPX3 may be arranged alternately in the first direction DR1 and/or the second direction DR2, and the second-color subpixels SPX2 may be arranged continuously and/or sequentially in the first direction DR1. The type, shape, and/or arrangement structure of the subpixels SPX1 through SPX3 may vary according to embodiments. In addition, the type, number, ratio, and/or arrangement structure of the subpixels SPX1 through SPX3 that form each unit pixel PX may vary according to embodiments.

The encapsulation layer 140 may be disposed on the pixels PX. In an embodiment, for example, the encapsulation layer 140 may be provided in at least the display area DA to cover the pixels PX, and a portion of the encapsulation layer 140 may extend to the non-display area NA.

Lines may be provided in the circuit layer 120 and located in the display area DA and the non-display area NA. In addition, the lines may be located in the sub-area SBA. In an embodiment, for example, the lines may extend from the sub-area SBA to the display area DA via the non-display area NA.

The non-display area NA may be located around the display area DA. In an embodiment, for example, the non-display area NA may be an edge area of the main area MA which is located outside the display area DA.

The non-display area NA may include a dam area DAMA spaced apart from the display area DA, a first non-display area NA1 between the display area DA and the dam area DAMA, and a second non-display area NA2 outside the dam area DAMA. The dam area DAMA may be an area where a dam surrounding the display area DA is disposed. The second non-display area NA2 may include an inorganic encapsulation area IEA (also referred to as a "bonding area") where inorganic encapsulation layers of the encapsulation layer 140 are bonded to each other.

The sub-area SBA may include the bank area BNKA, the driving circuit mounting area ICA, and the pad area PA sequentially disposed on one side of the main area MA. Lines (or portions of the lines), a bank, and pads PD may be disposed in the sub-area SBA. At least some of the lines may extend to the main area MA and may be connected to the pixels PX.

The bank area BNKA may be an area where a bank including at least one organic layer is disposed. In an embodiment, the bank area BNKA may include the bending area BA. In an embodiment, for example, the bank area BNKA may include the bending area BA spaced apart from the main area MA and a first edge area BEA1 and a second edge area BEA2 located on opposite sides of the bending area BA in the first direction DR1. The bank may be provided in the bending area BA and areas around the bending area BA (e.g., the first edge area BEA1 and the second edge area BEA2 of the bank area BNKA) to cover lines passing through the bending area BA. The display panel 100 may be bent in the bending area BA such that a portion of the sub-area SBA is located on a rear surface of the main area MA.

The driving circuit mounting area ICA may be an area where the driver 200 is disposed. Pads for connecting at least some lines to the driver 200 may be disposed in the driving circuit mounting area ICA. In an embodiment, for example, input pads for connecting the driver 200 to certain pads (e.g., data input pads) of the pad area PA and output pads for connecting the driver 200 to the pixels PX may be disposed in the driving circuit mounting area ICA.

In some embodiments, the driver 200 may not be disposed on the display panel 100. In this case, the display panel 100 may not include the driving circuit mounting area ICA, and only lines may be disposed in an area between the bank area BNKA and the pad area PA.

The pad area PA may be an area where the pads PD for connecting the display panel 100 and/or the driver 200 to the circuit board 300 or the like are disposed. The circuit board 300 may be disposed or bonded on the pad area PA.

A plurality of pads PD including power pads and signal pads connected to the pixels PX, the driver 200, and/or an embedded circuit may be disposed in the pad area PA. Power voltages for driving the pixels PX, the driver 200, and/or the embedded circuit may be supplied to the power pads. Driving signals and/or image data for driving the pixels PX, the driver 200, and/or the embedded circuit may be supplied to the signal pads. The type, location, arrangement order, and/or number of pads PD may vary according to embodiments.

FIG. 6 is a pixel circuit diagram of a subpixel SPX according to an embodiment. FIG. 7 is a pixel circuit diagram of a subpixel SPX according to an embodiment.

FIGS. 6 and 7 show different embodiments of a pixel circuit PCA and lines connected to the pixel circuit PCA. The configuration of the pixel circuit PCA and the type and number of lines connected to the pixel circuit PCA may vary according to embodiments.

FIG. 6 illustrates an embodiment in which each pixel circuit PCA includes first through seventh transistors T1 through T7. In an embodiment, scan lines SL connected to the subpixel SPX of FIG. 6 may include a first scan line SL1, a second scan line SL2, a third scan line SL3 and a fourth scan line SL4, and power lines PL connected to the subpixel SPX of FIG. 6 may include a first pixel power line VDL, a second pixel power line VSL, a first initialization power line VIL and a second initialization power line VAIL. The subpixel SPX of FIG. 6 may be further connected to an emission control line ECL.

FIG. 7 illustrates an embodiment in which each pixel circuit PCA includes first through eighth transistors T1 through T8. In an embodiment, scan lines SL connected to the subpixel SPX of FIG. 7 may include a first scan line SL1, a second scan line SL2, a third scan line SL3 and a fifth scan line SL5, and power lines PL connected to the subpixel SPX of FIG. 7 may include a first pixel power line VDL, a second pixel power line VSL, a first initialization power line VIL, a second initialization power line VAIL and a bias power line VOBL. The subpixel SPX of FIG. 7 may be further connected to an emission control line ECL.

Referring to FIG. 6, the subpixel SPX may include a light emitting unit EMU including at least one light emitting element EL and a pixel circuit PCA (also referred to as a "pixel driver") connected to the light emitting unit EMU.

The light emitting element EL may be connected between the second pixel power line VSL to which a second pixel power voltage ELVSS is applied and the pixel circuit PCA. In an embodiment, the second pixel power voltage ELVSS may be a low-potential pixel driving voltage. The light emitting element EL may be a light source of a pixel PX and may emit light in response to a driving current supplied from the pixel circuit PCA.

The light emitting element EL may be an organic light emitting diode. However, the disclosure is not limited thereto. For another example, the light emitting element EL may also be an inorganic light emitting element, a quantum dot light emitting element, or other types of light emitting elements.

The pixel circuit PCA may control the light emission timing and brightness of the light emitting element EL by controlling a driving current supplied to the light emitting element EL. The pixel circuit PCA may include at least one pixel transistor T and a capacitor Cst. In an embodiment, the pixel circuit PCA may include pixel transistors T including the first through seventh transistors T1 through T7.

The first transistor T1 may include a gate electrode connected to a first node N1, a first electrode electrically connected to the first pixel power line VDL through the fifth transistor T5, and a second electrode electrically connected to the light emitting unit EMU through the sixth transistor T6. One of the first electrode and the second electrode may be a source electrode, and the other may be a drain electrode. The first transistor T1 may control a source-drain current (hereinafter, referred to as a "driving current") flowing between the first electrode and the second electrode according to a voltage applied to the gate electrode (e.g., a voltage of the first node N1 corresponding to a voltage of a data signal). In an embodiment, for example, the first transistor T1 may be a driving transistor of the subpixel SPX.

The second transistor T2 may include a gate electrode connected to the first scan line SL1, a first electrode connected to a data line DL, and a second electrode connected to the first electrode of the first transistor T1. The second transistor T2 may be turned on by a first scan signal supplied to the first scan line SL1 to electrically connect the first electrode of the first transistor T1 to the data line DL. When the second transistor T2 is turned on, the voltage of a data signal supplied to the data line DL may be applied to the first electrode of the first transistor T1.

The third transistor T3 may include a gate electrode connected to the second scan line SL2, a first electrode connected to the second electrode of the first transistor T1, and a second electrode connected to the gate electrode of the first transistor T1 (or the first node N1). The third transistor T3 may be turned on by a second scan signal supplied to the second scan line SL2 to electrically connect the gate electrode and the second electrode of the first transistor T1. When the third transistor T3 is turned on, the first transistor T1 may operate as a diode.

The fourth transistor T4 may include a gate electrode connected to the third scan line SL3, a first electrode connected to the gate electrode of the first transistor T1, and a second electrode connected to the first initialization power line VIL. The fourth transistor T4 may be turned on by a third scan signal supplied to the third scan line SL3 to electrically connect the gate electrode of the first transistor T1 to the first initialization power line VIL. When the fourth transistor T4 is turned on, a first initialization voltage VINT (e.g., a gate initialization voltage) of the first initialization power line VIL may be applied to the gate electrode of the first transistor T1.

The fifth transistor T5 may include a gate electrode connected to the emission control line ECL, a first electrode connected to the first pixel power line VDL, and a second electrode connected to the first electrode of the first transistor T 1. The fifth transistor T5 may be turned on by an emission control signal supplied to the emission control line ECL to electrically connect the first electrode of the first transistor T1 to the first pixel power line VDL to which a first pixel power voltage ELVDD is applied. When the fifth transistor T5 is turned on, the first pixel power voltage ELVDD may be applied to the first electrode of the first transistor T1. In an embodiment, the first pixel power voltage ELVDD may be a high-potential pixel driving voltage.

The sixth transistor T6 may include a gate electrode connected to the emission control line ECL, a first electrode connected to the second electrode of the first transistor T 1, and a second electrode connected to the light emitting element EL. The sixth transistor T6 may be turned on by an emission control signal supplied to the emission control line ECL to electrically connect the first transistor T1 to the light emitting element EL. When both the fifth transistor T5 and the sixth transistor T6 are turned on, a driving current of a magnitude corresponding to the voltage of the gate electrode of the first transistor T1 may flow to the light emitting element EL.

The seventh transistor T7 may include a gate electrode connected to the fourth scan line SL4, a first electrode connected to an anode of the light emitting element EL, and a second electrode connected to the second initialization power line VAIL. The seventh transistor T7 may be turned on by a fourth scan signal supplied to the fourth scan line SL4 to electrically connect the anode of the light emitting element EL to the second initialization power line VAIL. The fourth scan signal may be the same signal as or a different signal from the first scan signal. When the seventh transistor T7 is turned on, a second initialization voltage VAINT (e.g., an anode initialization voltage) of the second initialization power line VAIL may be applied to the anode of the light emitting element EL.

The capacitor Cst may be connected between the gate electrode of the first transistor T1 and the first pixel power line VDL. The capacitor Cst may be charged with a voltage corresponding to the voltage of a data signal applied to the gate electrode of the first transistor T1.

An active layer (e.g., a semiconductor pattern including a channel region) of each of the pixel transistors T (e.g., the first through seventh transistors T1 through T7) may include one semiconductor material selected from polysilicon, amorphous silicon, and an oxide semiconductor. In an embodiment, some of the pixel transistors T and the other pixel transistors T may be formed as transistors of different conductivity types. In addition, some of the pixel transistors T and the other pixel transistors T may include different types of semiconductor materials.

In an embodiment, for example, the first, second, fifth, sixth and seventh transistors T1, T2, T5, T6 and T7 may be formed as P-type transistors (e.g., P-type MOSFETs), each including an active layer made of polysilicon, and the third and fourth transistors T3 and T4 may be formed as N-type transistors (e.g., N-type MOSFETs), each including an active layer made of an oxide semiconductor. In an embodiment, transistors, each including an active layer made of polysilicon, and transistors, each including an active layer made of an oxide semiconductor, may be disposed in different layers within the circuit layer 120.

Referring to FIG. 7 in addition to FIG. 6, the pixel circuit PCA may further include the eighth transistor T8. The eighth transistor T8 may include a gate electrode connected to the fifth scan line SL5, a first electrode connected to the bias power line VOBL, and a second electrode connected to a first electrode of the first transistor T1. The eighth transistor T8 may be turned on by a fifth scan signal supplied to the fifth scan line SL5 to electrically connect the first electrode of the first transistor T1 to the bias power line VOBL. When the eighth transistor T8 is turned on, a bias voltage VOBS supplied to the bias power line VOBL may be applied to the first electrode of the first transistor T1. In an embodiment, the bias voltage VOBS may have a voltage level suitable for compensating hysteresis characteristics of the first transistor T1. As the eighth transistor T8 is turned on, the first electrode of the first transistor T1 may be initialized to the bias voltage VOBS.

In the embodiment of FIG. 7, a gate electrode of the seventh transistor T7 may be connected to the fifth scan line SL5. Accordingly, the seventh transistor T7 may be turned on by the fifth scan signal supplied to the fifth scan line SL5 to connect an anode of a light emitting element EL to the second initialization power line VAIL.

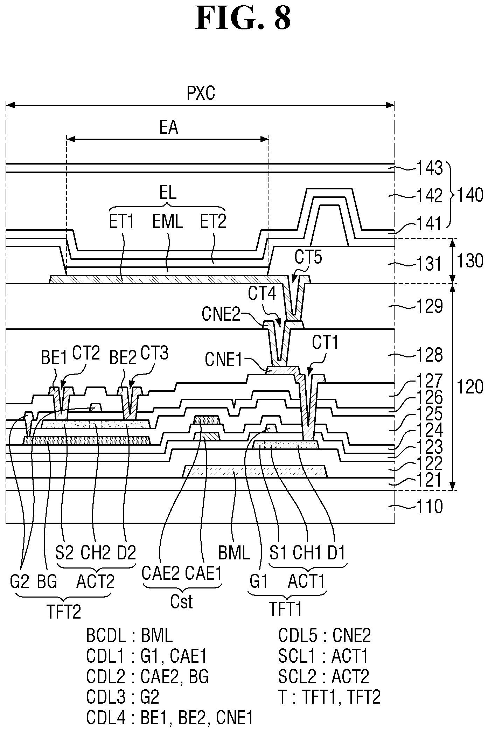

FIG. 8 is a cross-sectional view of a subpixel SPX of the display device 10 according to the embodiment. FIG. 8 is a cross-sectional view of a portion of an area corresponding to a subpixel SPX of the display area DA.

Referring to FIG. 8, the display panel 100 may include the substrate 110 and the circuit layer 120, the light emitting element layer 130 and the encapsulation layer 140 disposed on the substrate 110. The circuit layer 120, the light emitting element layer 130, and the encapsulation layer 140 may be sequentially disposed or stacked on the substrate 110 along the third direction DR3.

The substrate 110 may be made of a flexible material that can be bent, folded, or rolled. The substrate 110 may be made of an insulating material such as polymer resin. In an embodiment, for example, the substrate 110 may be made of polyimide.

The circuit layer 120 may include pixel circuits PXC and lines. In an embodiment, for example, the circuit layer 120 may include circuit elements (e.g., pixel transistors T and a capacitor Cst) constituting the pixel circuit PXC of each subpixel SPX and lines (e.g., various power lines and signal lines including power lines PL, scan lines SL, emission control lines ECL, and data lines DL) electrically connected to the subpixels SPX.

FIG. 8 illustrates a first thin-film transistor TFT1 (also referred to as a "first pixel transistor"), a second thin-film transistor TFT2 (also referred to as a "second pixel transistor"), and a capacitor Cst included in the pixel circuit PXC of each subpixel SPX among the elements that can be provided in the circuit layer 120. The first thin-film transistor TFT1 may be a first-type transistor (e.g., P-type transistor) including a first semiconductor material (e.g., polysilicon) among the pixel transistors T constituting each pixel circuit PXC. In an embodiment, for example, the first thin-film transistor TFT1 may be one of the first, second, fifth, sixth, seventh, and/or eighth transistors T1, T2, T5, T6, T7, and/or T8. In FIG. 8, one transistor (e.g., the sixth transistor T6 of FIG. 6 or FIG. 7) connected to a light emitting element EL through at least one connection electrode (e.g., a first connection electrode CNE1 and a second connection electrode CNE2) among the first-type transistors is illustrated as an example of the first thin-film transistor TFT1. The second thin-film transistor TFT2 may be a second-type transistor (e.g., N-type transistor) including a second semiconductor material (e.g., an oxide semiconductor) among the pixel transistors T. In an embodiment, for example, the second thin-film transistor TFT2 may be one of the third and fourth transistors T3 and T4.

The cross-sections of the subpixels SPX may vary according to the type and/or structure of each subpixel SPX and the display panel 100 including the subpixels SPX. In an embodiment, for example, the positions and formation order of the first thin-film transistor TFT1, the second thin-film transistor TFT2, and the capacitor Cst may vary according to embodiments.

The circuit layer 120 may include semiconductor layers and conductive layers for forming circuit elements and lines and insulating layers disposed between and/or around the conductive layers and the semiconductor layers. In an embodiment, for example, the circuit layer 120 may include a first semiconductor layer SCL1 (e.g., a polysilicon semiconductor layer), a first insulating layer 123 (e.g., a first gate insulating layer), a first conductive layer CDL1 (e.g., a first gate conductive layer), a second insulating layer 124 (e.g., a second gate insulating layer), a second conductive layer CDL2 (e.g., a second gate conductive layer), a third insulating layer 125 (e.g., a first interlayer-insulating layer), a second semiconductor layer SCL2 (e.g., an oxide semiconductor layer), a fourth insulating layer 126 (e.g., a third gate insulating layer), a third conductive layer CDL3 (e.g., a third gate conductive layer), a fifth insulating layer 127 (e.g., a second interlayer-insulating layer), a fourth conductive layer CDL4 (e.g., a first source-drain conductive layer), and a sixth insulating layer 128 (e.g., a first-via-layer or a first planarization layer) sequentially disposed on the substrate 110 in the third direction DR3. In an embodiment, the circuit layer 120 may further include a fifth conductive layer CDL5 (e.g., a second source-drain conductive layer) and a seventh insulating layer 129 (e.g., a second-via-layer or a second planarization layer) sequentially disposed on the sixth insulating layer 128. In an embodiment, the circuit layer 120 may further include a bottom conductive layer BCDL disposed between the substrate 110 and the first semiconductor layer SCL1, a barrier layer 121 disposed between the substrate 110 and the bottom conductive layer BCDL, and a buffer layer 122 disposed between the bottom conductive layer BCDL and the first semiconductor layer SCL1.

The barrier layer 121 may be disposed on the substrate 110. The barrier layer 121 may protect elements disposed in the circuit layer 120 and the light emitting element layer 130 from moisture introduced through the substrate 110 which is vulnerable to moisture penetration. The barrier layer 121 may include at least one inorganic layer including an inorganic insulating material (e.g., silicon nitride, silicon oxide, silicon oxynitride, titanium oxide, aluminum oxide, or other inorganic insulating materials). The material of the barrier layer 121 may vary according to embodiments.

The bottom conductive layer BCDL may be disposed on the barrier layer 121. The bottom conductive layer BCDL may include a bottom metal layer BML overlapping an active layer (e.g., a first active layer ACT1 and/or a second active layer ACT2) of at least one pixel transistor T and/or at least one line (or a portion of the at least one line) in a normal direction of the substrate 110. In FIG. 8, the bottom metal layer BML overlaps only the first active layer ACT1 of the first thin-film transistor TFT1 and capacitor electrodes CAE1 and CAE2 of the capacitor Cst in a normal direction of the substrate 110, but the disclosure is not limited thereto. In an embodiment, for example, the bottom metal layer BML may be patterned into an appropriate size and/or shape and thus disposed in a portion of the pixel circuit PXC or may be disposed in the entire pixel circuit PXC. In an embodiment, for example, the bottom metal layer BML may be disposed only in a portion of a pixel area to overlap the first transistor T1 in a normal direction of the substrate 110 illustrated in FIGS. 6 and 7. In an embodiment, the bottom metal layer BML may be used as a light blocking pattern and/or a back-gate electrode of at least one pixel transistor T.

The buffer layer 122 may be disposed on the bottom conductive layer BCDL to cover the bottom conductive layer BCDL. The buffer layer 122 may include at least one inorganic layer including an inorganic insulating material.

The first thin-film transistor TFT1, the second thin-film transistor TFT2, and the capacitor Cst may be disposed on a surface of the substrate 110 including the buffer layer 122. The first thin-film transistor TFT1 may include the first active layer ACT1 and a first gate electrode G1. The second thin-film transistor TFT2 may include the second active layer ACT2 and a second gate electrode G2. In an embodiment, the second thin-film transistor TFT2 may include a back-gate electrode BG. The capacitor Cst may include a first capacitor electrode CAE1 and a second capacitor electrode CAE2.

The first semiconductor layer SCL1 may be disposed on the buffer layer 122. The first semiconductor layer SCL1 may include the first active layer ACT1 of the first thin-film transistor TFT1. In an embodiment, for example, the first semiconductor layer SCL1 may include the first active layer ACT1 of each of the first, second, fifth, sixth, seventh and/or eighth transistors T1, T2, T5, T6, T7, and/or T8.

The first active layer ACT1 may be provided in the first semiconductor layer SCL1 and may include a first semiconductor material (e.g., polysilicon). The first active layer ACT1 may include a first channel region CH1, a first source region S1, and a first drain region D1. The first channel region CH1 may overlap the first gate electrode G1 in the third direction DR3. The first source region S1 may be disposed on a side of the first channel region CH1, and the first drain region D1 may be disposed on the other side of the first channel region CH1. The first source region S1 and the first drain region D1 may be regions formed to have conductivity by doping a semiconductor for forming the first active layer ACT1 with ions or impurities. In an embodiment, the first source region S1 may be a source electrode of the first thin-film transistor TFT1. In an embodiment, the first thin-film transistor TFT1 may include a separate source electrode connected to the first source region S1. In an embodiment, the first drain region D1 may be a drain electrode of the first thin-film transistor TFT1. In an embodiment, the first thin-film transistor TFT1 may include a separate drain electrode connected to the first drain region D 1.

The first insulating layer 123 may be disposed on the first semiconductor layer SCL1. The first insulating layer 123 may cover the first semiconductor layer SCL1.

The first conductive layer CDL1 may be disposed on the first insulating layer 123. The first conductive layer CDL1 may include the first gate electrode G1 of the first thin-film transistor TFT1. The first gate electrode G1 may overlap a portion of the first active layer ACT1 (e.g., the first channel region CH1) in a normal direction of the substrate 110. In an embodiment, the first conductive layer CDL1 may further include at least one line (or a portion of the at least one line), a metal pattern (e.g., a bridge pattern), and/or a capacitor electrode. In an embodiment, for example, the first conductive layer CDL1 may further include the first capacitor electrode CAE1 of the capacitor Cst.

In an embodiment, the first capacitor electrode CAE1 may be formed integrally with the gate electrode of at least one first thin-film transistor TFT1. In an embodiment, for example, the first capacitor electrode CAE1 may be formed integrally with the gate electrode of the first transistor T1 illustrated in FIGS. 6 and 7. In an embodiment, for example, the first capacitor electrode CAE1 and the gate electrode of the first transistor T1 may be formed as one conductive pattern, and the second capacitor electrode CAE2 may be disposed to overlap the conductive pattern in a normal direction of the substrate 110.

The second insulating layer 124 may be disposed on the first conductive layer CDL 1. The second insulating layer 124 may cover the first conductive layer CDL1.

The second conductive layer CDL2 may be disposed on the second insulating layer 124. The second conductive layer CDL2 may include one electrode of the capacitor Cst, for example, the second capacitor electrode CAE2. In an embodiment, the second conductive layer CDL2 may further include at least one electrode, at least one line (or a portion of the at least one line), and/or a metal pattern (e.g., a bridge pattern). In an embodiment, for example, the second conductive layer CDL2 may further include the back-gate electrode BG connected to the second gate electrode G2 of the second thin-film transistor TFT2.

The third insulating layer 125 may be disposed on the second conductive layer CDL2. The third insulating layer 125 may cover the second conductive layer CDL2.

The second semiconductor layer SCL2 may be disposed on the third insulating layer 125. The second semiconductor layer SCL2 may include the second active layer ACT2 of the second thin-film transistor TFT2. In an embodiment, for example, the second semiconductor layer SCL2 may include the second active layer ACT2 of each of the third and fourth transistors T3 and T4.

The second active layer ACT2 may be provided in the second semiconductor layer SCL2 and may include a second semiconductor material (e.g., an oxide semiconductor) different from the first semiconductor material. In an embodiment, for example, the second active layer ACT2 may include IGZO (indium (In), gallium (Ga), zinc (Zn), and oxygen (O)), IGZTO (indium (In), gallium (Ga), zinc (Zn), tin (Sn), and oxygen (O)), or IGTO (indium (In), gallium (Ga), tin (Sn), and oxygen (O)).

The second active layer ACT2 may include a second channel region CH2, a second source region S2, and a second drain region D2. The second channel region CH2 may overlap the second gate electrode G2 in the third direction DR3. The second source region S2 may be disposed on a side of the second channel region CH2, and the second drain region D2 may be disposed on the other side of the second channel region CH2. The second source region S2 and the second drain region D2 may be regions formed to have conductivity by doping a semiconductor for forming the second active layer ACT2 with ions or impurities. In an embodiment, the second source region S2 may be a source electrode of the second thin-film transistor TFT2. In an embodiment, the second thin-film transistor TFT2 may include a separate source electrode connected to the second source region S2. In an embodiment, the second drain region D2 may be a drain electrode of the second thin-film transistor TFT2. In an embodiment, the second thin-film transistor TFT2 may include a separate drain electrode connected to the second drain region D2.

The fourth insulating layer 126 may be disposed on the second semiconductor layer SCL2. The fourth insulating layer 126 may cover the second semiconductor layer SCL2.

The third conductive layer CDL3 may be disposed on the fourth insulating layer 126. The third conductive layer CDL3 may include the second gate electrode G2 of the second thin-film transistor TFT2. The second gate electrode G2 may overlap a portion of the second active layer ACT2 (e.g., the second channel region CH2) in a normal direction of the substrate 110. In an embodiment, the third conductive layer CDL3 may further include at least one line (or a portion of the at least one line), a metal pattern (e.g., a bridge pattern), and/or a capacitor electrode.

In an embodiment, each of the electrodes, the conductive patterns, and/or the lines provided in the bottom conductive layer BCDL, the first conductive layer CDL1, the second conductive layer CDL2, and the third conductive layer CLD3 may include a conductive material (e.g., at least one of molybdenum (Mo), aluminium (Al), chromium (Cr), gold (Au), titanium (Ti), nickel (Ni), neodymium (Nd), copper (Cu) and other metals, an alloy thereof, or other conductive materials) and may have a single-layer or multilayer structure. In an embodiment, for example, each of the electrodes, the conductive patterns, and/or the lines provided in the bottom conductive layer BCDL, the first conductive layer CDL1, the second conductive layer CDL2, and the third conductive layer CLD3 may include molybdenum (Mo) or other metal materials. At least two of the bottom conductive layer BCDL, the first conductive layer CDL1, the second conductive layer CDL2, and the third conductive layer CLD3 may include the same material or different materials. The material of each of the bottom conductive layer BCDL, the first conductive layer CDL1, the second conductive layer CDL2, and the third conductive layer CLD3 is not limited and may vary according to embodiments.

The fifth insulating layer 127 may be disposed on the third conductive layer CDL3. The fifth insulating layer 127 may cover the third conductive layer CDL3.

In an embodiment, each of the first insulating layer 123, the second insulating layer 124, the third insulating layer 125, the fourth insulating layer 126, and the fifth insulating layer 127 may be an inorganic insulating layer including an inorganic insulating material (e.g., silicon nitride, silicon oxide, silicon oxynitride, titanium oxide, aluminium oxide, or other inorganic insulating materials) and may have a single-layer or multilayer structure. At least two of the first insulating layer 123, the second insulating layer 124, the third insulating layer 125, the fourth insulating layer 126, and the fifth insulating layer 127 may include the same material or different materials. The material of each of the first insulating layer 123, the second insulating layer 124, the third insulating layer 125, the fourth insulating layer 126, and the fifth insulating layer 127 may vary according to embodiments.

The fourth conductive layer CDL4 may be disposed on the fifth insulating layer 127. The fourth conductive layer CDL4 may include the first connection electrode CNE1 (or the drain electrode of the first thin-film transistor TFT1), a first bridge electrode BE1 (or the source electrode of the second thin-film transistor TFT2), and a second bridge electrode BE2 (or the drain electrode of the second thin-film transistor TFT2). The first connection electrode CNE1 may be provided in the fourth conductive layer CDL4 and connected to the first drain region D1 of the first active layer ACT1 through a first contact hole CT1 penetrating the first insulating layer 123, the second insulating layer 124, the third insulating layer 125, the fourth insulating layer 126, and the fifth insulating layer 127. The first bridge electrode BE1 may be provided in the fourth conductive layer CDL4 and connected to the second source region S2 of the second active layer ACT2 through a second contact hole CT2 penetrating the fourth insulating layer 126 and the fifth insulating layer 127. The second bridge electrode BE2 may be connected to the second drain region D2 of the second active layer ACT2 through a third contact hole CT3 penetrating the fourth insulating layer 126 and the fifth insulating layer 127. In an embodiment, the fourth conductive layer CDL4 may further include at least one line (or a portion of the at least one line) and/or a metal pattern (e.g., a bridge pattern). In an embodiment, for example, the fourth conductive layer CDL4 may include a portion of a power line PL (e.g., the first pixel power line VDL and/or the second pixel power line VSL) provided inside and/or outside the display area DA.

The sixth insulating layer 128 may be disposed on the fourth conductive layer CDL4. The sixth insulating layer 128 may cover the fourth conductive layer CDL4.

The fifth conductive layer CDL5 may be disposed on the sixth insulating layer 128. The fifth conductive layer CDL5 may include the second connection electrode CNE2. The second connection electrode CNE2 may be provided in the fifth conductive layer CDL5 and connected to the first connection electrode CNE1 through a fourth contact hole CT4 (or a first-via-hole) penetrating the sixth insulating layer 128. In an embodiment, the fifth conductive layer CDL5 may further include at least one line (or a portion of the at least one line) and/or a metal pattern (e.g., a bridge pattern). In an embodiment, for example, the fifth conductive layer CDL5 may include a portion of a power line PL (e.g., the first pixel power line VDL and/or the second pixel power line VSL) provided inside and/or outside the display area DA.

In an embodiment, each of the electrodes, the conductive patterns, and/or the lines provided in the fourth conductive layer CDL4 and the fifth conductive layer CDL5 may include a conductive material (e.g., at least one of molybdenum (Mo), aluminium (Al), chromium (Cr), gold (Au), titanium (Ti), nickel (Ni), neodymium (Nd), copper (Cu) and other metals, an alloy thereof, or other conductive materials) and may have a single-layer or multilayer structure. In an embodiment, for example, each of the electrodes, the conductive patterns, and/or the lines provided in the fourth conductive layer CDL4 and the fifth conductive layer CDL5 may have a triple-layer structure of titanium/aluminium/titanium (Ti/Al/Ti). The fourth conductive layer CDL4 and the fifth conductive layer CDL5 may include the same material or different materials. The material of each of the fourth conductive layer CDL4 and the fifth conductive layer CDL5 may vary according to embodiments.

The seventh insulating layer 129 may be disposed on the fifth conductive layer CDL5. The seventh insulating layer 129 may cover the fifth conductive layer CDL5.

In an embodiment, each of the sixth insulating layer 128 and the seventh insulating layer 129 may be an organic insulating layer including an organic insulating material (e.g., acryl resin, epoxy resin, phenolic resin, polyamide resin, polyimide resin, or other organic insulating materials) to planarize the circuit layer 120 and may have a single-layer or multilayer structure. The sixth insulating layer 128 and the seventh insulating layer 129 may include the same material or different materials. The material of each of the sixth insulating layer 128 and the seventh insulating layer 129 may vary according to embodiments.

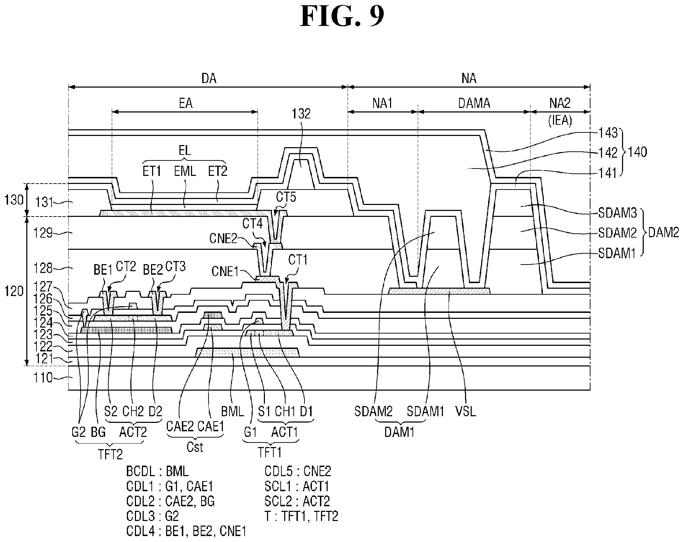

The light emitting element layer 130 may include a pixel defining layer 131 separating emission areas EA of the pixels PX and light emitting elements EL located in the emission areas EA, respectively. In an embodiment, the light emitting element layer 130 may further include a spacer 132 (see FIG. 9) disposed on a portion of the pixel defining layer 131.

Each light emitting element EL may include a first electrode ET1 (e.g., an anode) connected to at least one transistor T (e.g., the first thin-film transistor TFT1) included in a corresponding subpixel SPX through the first connection electrode CNE1 and/or the second connection electrode CNE2 and a light emitting layer EML and a second electrode ET2 (e.g., a cathode) sequentially disposed on the first electrode ET1. In an embodiment, each light emitting element EL may further include a first intermediate layer (e.g., a hole layer including a hole transport layer) interposed between the first electrode ET1 and the light emitting layer EML and a second intermediate layer (e.g., an electron layer including an electron transport layer) interposed between the light emitting layer EML and the second electrode ET2.

The first electrode ET1 of each light emitting element EL may include a conductive material and may be disposed on the circuit layer 120. In an embodiment, for example, the first electrode ET1 may be disposed on the seventh insulating layer 129 in each emission area EA. The first electrode ET1 may be connected to the second connection electrode CNE2 through a fifth contact hole CT5 (or a second-via-hole) penetrating the seventh insulating layer 129.

In an embodiment, the first electrode ET1 may include a metal material having high reflectivity. In an embodiment, for example, the first electrode ET1 may have a single-layer structure of molybdenum (Mo), titanium (Ti), copper (Cu) or aluminium (Al) or may have a multilayer structure (e.g., ITO/Mg, ITO/MgF, ITO/Ag, or ITO/Ag/ITO) including indium-tin-oxide (ITO), indium-zinc-oxide (IZO), zinc oxide (ZnO) or indium oxide (In₂O₃) and silver (Ag), magnesium (Mg), aluminium (Al), platinum (Pt), lead (Pb), gold (Au) or nickel (Ni).

The light emitting layer EML of each light emitting element EL may include a high molecular weight material or a low molecular weight material. In an embodiment, the light emitting layer EML may be provided for each subpixel SPX, and the light emitting layer EML of each subpixel SPX may emit visible light of a color corresponding to the subpixel SPX. In an embodiment, the light emitting layer EML may be a common layer shared by subpixels SPX of different colors, and a wavelength conversion layer and/or a color filter corresponding to a color (or wavelength band) of light to be emitted from each subpixel SPX may be disposed in the emission areas EA of at least some of the subpixels SPX.

The second electrode ET2 of each light emitting element EL may include a conductive material and may be connected to the second pixel power line VSL. In an embodiment, the second electrode ET2 may be a common layer formed over the entire display area DA to cover the light emitting layers EML and the pixel defining layer 131. In an embodiment, the second electrode ET2 may be made of a transparent conductive material (TCO) that can transmit light, such as ITO or IZO, or a semi-transmissive conductive material such as magnesium (Mg), silver (Ag) or an alloy of Mg and Ag. When the second electrode ET2 is made of a semi-transmissive conductive material, an improvement in light output efficiency by a microcavity effect can be expected.

The pixel defining layer 131 may define openings corresponding to the emission areas EA, respectively, and may surround the emission areas EA. In an embodiment, for example, the pixel defining layer 131 may be formed to cover edges of the first electrode ET1 of each light emitting element EL and may define an opening exposing the other portion of the first electrode ET1. An area where the exposed first electrode ET1 and the light emitting layer EML overlap (or an area including them) in a normal direction of the substrate 110 may be defined as the emission area EA of each pixel PX.

In an embodiment, the pixel defining layer 131 may include at least one organic layer including an organic insulating material. In an embodiment, for example, the pixel defining layer 131 may include polyacrylates resin, epoxy resin, phenolic resin, polyamides resin, polyimides resin, unsaturated polyesters resin, polyphenylenethers resin, polyphenylenesulfides resin or benzocyclobutene (BCB) or may include other organic insulating materials.

The spacer 132 may be disposed on a portion of the pixel defining layer 131. The spacer 132 may include at least one organic layer including an organic insulating material. The spacer 132 may include the same material as the pixel defining layer 131 or may include a different material from the pixel defining layer 131. In an embodiment, the pixel defining layer 131 and the spacer 132 may be sequentially formed through respective mask processes. In an embodiment, the pixel defining layer 131 and the spacer 132 may be simultaneously formed using a halftone mask. In this case, the pixel defining layer 131 and the spacer 132 may be considered as one integrated insulating layer. The organic insulating material that forms the spacer 132 is not particularly limited and may vary according to embodiments.

The encapsulation layer 140 may be disposed on the light emitting element layer 130 in the main area MA. In an embodiment, for example, the encapsulation layer 140 may be disposed in the display area DA and the non-display area NA to cover the light emitting element layer 130. The encapsulation layer 140 may block penetration of oxygen or moisture into the light emitting element layer 130 and reduce electrical or physical shock to the circuit layer 120 and the light emitting element layer 130.

In an embodiment, the encapsulation layer 140 may include a first inorganic encapsulation layer 141, an organic encapsulation layer 142, and a second inorganic encapsulation layer 143 sequentially disposed on the light emitting element layer 130. The first inorganic encapsulation layer 141 and the second inorganic encapsulation layer 143 may include an inorganic material, and the organic encapsulation layer 142 may include an organic material.

FIG. 9 is a cross-sectional view of an outer portion of the display panel 100 according to the embodiment. FIG. 9 illustrates a portion of the display area DA and a portion of the non-display area NA of the display panel 100.

Referring to FIG. 9, the display panel 100 may include a plurality of dam structures DAM1 and DAM2 disposed in the dam area DAMA of the non-display area NA. The dam structures DAM1 and DAM2 may surround the display area DA of the display panel 100 in a plan view. In an embodiment, for example, the dam structures DAM1 and DAM2 may include a first dam DAM1 surrounding the display area DA and a second dam DAM2 surrounding the first dam DAM1. The second dam DAM2 may be disposed closer to edges of the display panel 100 than the first dam DAM1. The display panel 100 including the dam structures DAM1 and DAM2 can prevent an organic material of the organic encapsulation layer 142 of the encapsulation layer 140 from overflowing.

In an embodiment, each of the first dam DAM1 and the second dam DAM2 may include a plurality of sub-dams SDAM1 through SDAM3. The sub-dams SDAM1 through SDAM3 may include the same material as a plurality of organic insulating material layers disposed in the display area DA, respectively, and may be formed at the same time as the organic insulating material layers. Alternatively, the sub-dams SDAM1 through SDAM3 may be disposed in the same layer as a plurality of organic insulating material layers disposed in the display area DA, respectively.

In an embodiment, for example, each of the first dam DAM1 and the second dam DAM2 may include a first sub-dam SDAM1 and a second sub-dam SDAM2 disposed on the first sub-dam SDAM1. The second dam DAM2 may further include a third sub-dam SDAM3 disposed on the second sub-dam SDAM2. The first sub-dam SDAM1 may include the same material as the sixth insulating layer 128 and may be disposed on substantially the same layer as the sixth insulating layer 128. The second sub-dam SDAM2 may include the same material as the seventh insulating layer 129 and may be disposed on substantially the same layer as the seventh insulating layer 129. The third sub-dam SDAM3 may include the same material as the pixel defining layer 131 and/or the spacer 132 and may be disposed on substantially the same layer as the pixel defining layer 131 and/or the spacer 132. The first sub-dam SDAM1, the second sub-dam SDAM2, and the third sub-dam SDAM3 may be considered as portions of the sixth insulating layer 128, the seventh insulating layer 129, and the pixel defining layer 131 and/or the spacer 132 disposed in the display area DA, respectively.

Since the first dam DAM1 and the second dam DAM2 are spaced apart from the display area DA, a valley may be formed between the dam area DAMA and the display area DA and/or between adjacent dams DAM. The organic encapsulation layer 142 may be prevented from overflowing to the edges of the display panel 100 by the valley. The organic encapsulation layer 142 may fill the valley between the first dam DAM1 and the display area DA.

The first inorganic encapsulation layer 141, the organic encapsulation layer 142, and the second inorganic encapsulation layer 143 of the encapsulation layer 140 may be disposed in the first non-display area NA1 between the first dam DAM1 and the display area DA and in the dam area DAMA of the non-display area NA. Since the organic encapsulation layer 142 does not extend beyond at least the second dam DAM2, it may not be disposed in the second non-display area NA2 between the second dam DAM2 and the edges in the non-display area NA. The first inorganic encapsulation layer 141 and the second inorganic encapsulation layer 143 of the encapsulation layer 140 may contact each other in the second non-display area NA2. The second non-display area NA2 where the first inorganic encapsulation layer 141 and the second inorganic encapsulation layer 143 contact each other may be the inorganic encapsulation area IEA. The inorganic encapsulation area IEA where the first inorganic encapsulation layer 141 and the second inorganic encapsulation layer 143 contact each other may be formed outside the second dam DAM2 to block a path through which moisture penetration from the outside may occur.

The display panel 100 may include the second pixel power line VSL disposed in the non-display area NA. The second pixel power line VSL may overlap the first dam DAM1 in a normal direction of the substrate 110 and may surround the display area DA. A portion of the second pixel power line VSL may not overlap the first dam DAM1 in a normal direction of the substrate 110 and may contact the second electrode ET2 of a light emitting element EL in the valley disposed between the first dam DAM1 and the display area DA. The second electrode ET2 of the light emitting element EL may receive a second power voltage from the second pixel power line VSL.

Although the first dam DAM1 and the second dam DAM2 are disposed on the second pixel power line VSL in FIG. 9, the disclosure is not limited thereto. For another example, any one of the first dam DAM1 and the second dam DAM2 may not be disposed on the second pixel power line VSL. Alternatively, neither the first dam DAM1 nor the second dam DAM2 may be disposed on the second pixel power line VSL. In this case, the first dam DAM1 and the second dam DAM2 may be disposed outside the second pixel power line VSL.

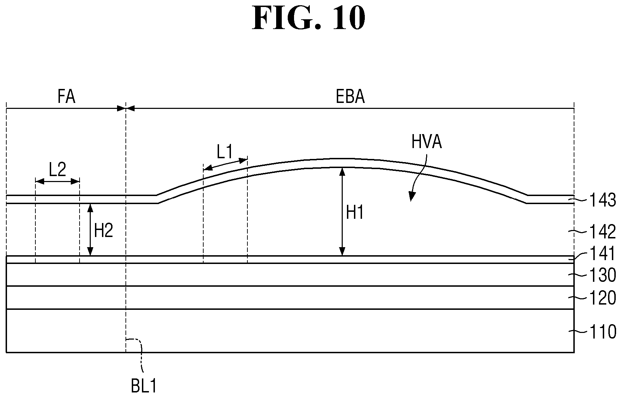

FIG. 10 is a schematic cross-sectional view of the encapsulation layer 140 in the flat portion FA and a bending portion EBA of the display device 10 in a flat state according to the embodiment.

Referring to FIG. 10, in the display device 10, the encapsulation layer 140 may be disposed over the flat portion FA and the bending portion EBA. Each of the first inorganic encapsulation layer 141, the organic encapsulation layer 142, and the second inorganic encapsulation layer 143 of the encapsulation layer 140 may be disposed in the flat portion FA and the bending portion EBA. The encapsulation layer 140 may protect the light emitting elements EL disposed over the flat portion FA and the bending portion EBA and may protect the display panel 100 from moisture penetration from the outside.

According to an embodiment, the organic encapsulation layer 142 of the encapsulation layer 140 in the display device 10 may have different cross-sectional shapes in the flat portion FA and the bending portion EBA. In an embodiment, for example, the organic encapsulation layer 142 of the encapsulation layer 140 may have a larger volume or amount of organic insulating material "per unit area" in the bending portion EBA than in the flat portion FA. A portion of the organic encapsulation layer 142 in the bending portion EBA may have a greater height than the organic encapsulation layer 142 in the flat portion FA. The organic encapsulation layer 142 may have an upwardly protruding portion in the bending portion EBA, and the protruding portion may form an area HVA in which the volume of organic insulating material per unit area is larger than the volume of organic insulating material per unit area in the flat portion FA. As used herein, the "unit area" is measured in a view in a normal direction of a major surface of the substrate 110, and the "height" is measured in the normal direction.

The display device 10 may include the bending portion EBA that is bent downward, unlike the flat portion FA. In the bending portion EBA, the substrate 110, the circuit layer 120, the light emitting element layer 130, and the encapsulation layer 140 may all be bent in one direction, for example, toward the bottom of the display device 10. The encapsulation layer 140 including the inorganic encapsulation layers 141 and 143 and the organic encapsulation layer 142 may be damaged by stress applied to a bent portion in the bending portion EBA. The display device 10 may be structured to relieve the stress applied to the encapsulation layer 140 and may prevent the encapsulation layer 140, especially the second inorganic encapsulation layer 143 in the bending portion EBA from being damaged by the stress.

In an embodiment, for example, the display device 10 may include the area HVA in which the organic encapsulation layer 142 has a larger volume per unit area in the bending portion EBA than in the flat portion FA. In the display device 10, a maximum height H1 of the organic encapsulation layer 142 measured in the bending portion EBA may be greater than a maximum height H2 of the organic encapsulation layer 142 measured in the flat portion FA. In addition, the display device 10 may have a structure in which the second inorganic encapsulation layer 143 has a greater length in the bending portion EBA than in the flat portion FA. As illustrated in the drawing, a surface length L1 of the second inorganic encapsulation layer 143 measured in a unit area of the bending portion EBA may be greater than a surface length L2 measured in a unit area of the flat portion FA. In other words, the surface length L1 of the second inorganic encapsulation layer 143 corresponding to a unit area of the bending portion EBA may be greater than the surface length L2 corresponding to a unit area of the flat portion FA. When the display device 10 is bent, the area HVA in which the organic encapsulation layer 142 has a large volume per unit area can offset a thinning portion in the bending portion EBA. In addition, when the second inorganic encapsulation layer 143 is bent, it can be effectively prevented from being damaged by stress.

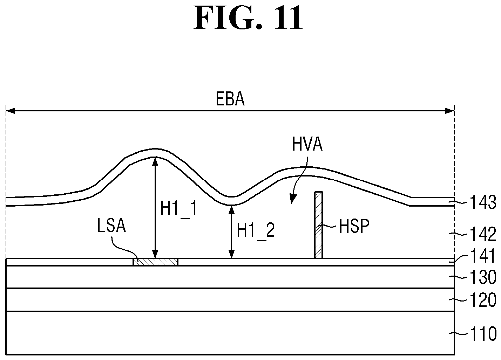

FIG. 11 is a cross-sectional view illustrating the structure of the organic encapsulation layer 142 of the encapsulation layer 140 in the bending portion EBA of FIG. 10 in detail. FIG. 11 illustrates curves of the organic encapsulation layer 142 in the bending portion EBA in detail.

Referring to FIG. 11 in addition to FIG. 10, the display device 10 may include an area LSA formed by surface-treating a portion of the first inorganic encapsulation layer 141 or a pattern portion HSP disposed on the first inorganic encapsulation layer 141 to form an area where a portion of the organic encapsulation layer 142 is raised. Although the display device 10 includes both the first area LSA of the first inorganic encapsulation layer 141 and the pattern portion HSP in the drawing, the disclosure is not limited thereto. The display device 10 may include one of the first area LSA of the first inorganic encapsulation layer 141 and the pattern portion HSP in another embodiment.

According to an embodiment, the first inorganic encapsulation layer 141 may include the surface-treated first area LSA and a second area other than the first area LSA in the bending portion EBA. The first area LSA may be an area surface-treated to have lower surface energy than the second area. When organic insulating materials are applied on the first inorganic encapsulation layer 141 in the bending portion EBA, organic insulating materials applied on the first area LSA among the organic insulating materials may agglomerate with each other. As the organic insulating materials applied around the first area LSA and the organic insulating materials applied on the first area LSA agglomerate with each other, the area on and around the first area LSA may be raised further upward than the surrounding area. Accordingly, the organic encapsulation layer 142 may be raised further on the first area LSA of the first inorganic encapsulation layer 141 or around the first area LSA than in other areas except for the area including the pattern portion HSP.

Alternatively, the display device 10 may include the pattern portion HSP disposed on the first inorganic encapsulation layer 141 and including a material with higher surface energy than the organic insulating materials surrounding the pattern portion HSP. The organic insulating materials applied on the first inorganic encapsulation layer 141 may agglomerate around the pattern portion HSP and form a raised area together with the organic insulating materials applied around the pattern portion HSP. Accordingly, the organic encapsulation layer 142 may be raised further in an area on the pattern portion HSP or around the pattern portion HSP than in other areas except for the area on the first area LSA. A height H1_1 of the organic encapsulation layer 142 in an area located on the first area LSA of the first inorganic encapsulation layer 141 or in an area overlapping the pattern portion HSP in a normal direction of the substrate 110 may be greater than a height H1_2 of the organic encapsulation layer 142 in other areas. The first area LSA of the first inorganic encapsulation layer 141 and/or the pattern portion HSP may be placed to correspond to an area that is bent most in the bending portion EBA of the display device 10 or an area in which the stress due to bending is greatest. Accordingly, the organic encapsulation layer 142 may have the greatest maximum height H1 in the area that is bent most in the bending portion EBA of the display device 10 or in the area in which the stress due to bending is greatest. A portion of the organic encapsulation layer 142 may have protruding and recessed patterns in the bending portion EBA according to the arrangement of the first area LSA of the first inorganic encapsulation layer 141 and/or the pattern portion HSP in the bending portion EBA. However, an average height of the organic encapsulation layer 142 may be greater in the bending portion EBA than in the flat portion FA.

When the organic insulating materials applied on the first inorganic encapsulation layer 141 are made to agglomerate in a specific area by the first area LSA of the first inorganic encapsulation layer 141 and/or the pattern portion HSP, organic insulating materials remaining in other areas may not be sufficient. In a process of fabricating the display device 10, the amount of organic insulating material applied per unit area may be larger in the bending portion EBA in which the first area LSA of the first inorganic encapsulation layer 141 and/or the pattern portion HSP are disposed than in the flat portion FA. Accordingly, in the display device 10, even though the organic insulating materials applied to the bending portion EBA agglomerate in a specific area, the volume of the organic encapsulation layer 142 per unit area may be larger in the bending portion EBA than in the flat portion FA.

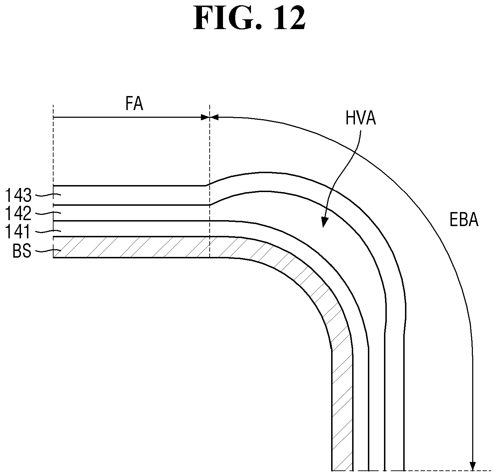

FIG. 12 illustrates the bending portion EBA of the display device 10 of FIG. 10 in a bent state.

Referring to FIG. 12, in the display device 10, a base unit BS including the substrate 110, the circuit layer 120 and the light emitting element layer 130 and the encapsulation layer 140 disposed on the base unit BS may be bent together in the bending portion EBA. The bending portion EBA may be bent toward a rear surface of the substrate 110 opposite a surface of the substrate on which the light emitting element layer 120 is disposed as shown in FIG. 12. The organic encapsulation layer 142 may include the area HVA in the bending portion EBA in which the volume of the organic encapsulation layer 142 per unit area is larger than in the flat portion FA. The area HVA may be positioned to correspond to an area that is bent most in the display device 10. The organic encapsulation layer 142 may become relatively thin in a portion where the display device 10 is bent compared to an unbent state (i.e., flat state). However, according to an embodiment, since the area HVA in which the volume of the organic encapsulation layer 142 per unit area is large is located in the bending portion EBA as described above, the thinning of the organic encapsulation layer 142 can be offset even in the bent state. In addition, the second inorganic encapsulation layer 143 disposed on the organic encapsulation layer 142 may have a greater surface length per unit area in a bent portion in the bending portion EBA than in the flat portion FA, and then the stress applied when the display device 10 is bent can be well distributed.

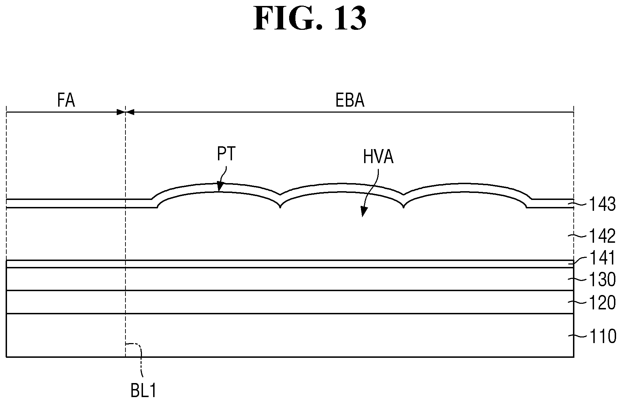

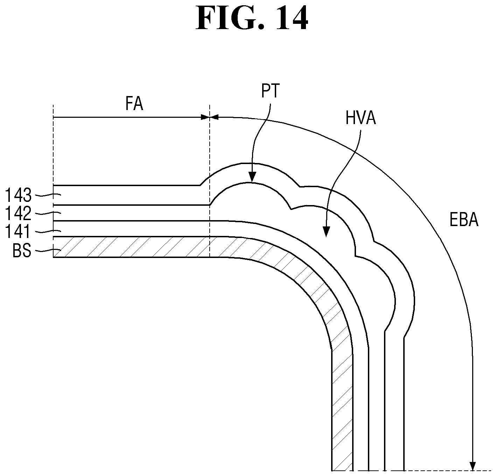

FIG. 13 is a schematic cross-sectional view of an encapsulation layer in a flat portion FA and a bending portion EBA of a display device 10 in a flat state according to an embodiment. FIG. 14 illustrates the bending portion EBA of the display device 10 of FIG. 13 in a bent state.

Referring to FIGS. 13 and 14, in the display device 10 according to the embodiment, an organic encapsulation layer 142 may include a plurality of raised patterns PT in the bending portion EBA. The organic encapsulation layer 142 may have a greater average height and a larger volume per unit area in the bending portion EBA than in the flat portion FA and may have a raised shape in some portions. While the organic encapsulation layer 142 forms one raised area in FIG. 10 or in the embodiment of FIG. 11, the disclosure is not limited thereto. Although not illustrated in detail in drawings, the raised patterns PT of the organic encapsulation layer 142 disposed in the bending portion EBA of the display device 10 may be formed by the first area LSA of the first inorganic encapsulation layer 141 and/or the pattern portion HSP illustrated in FIG. 11. If the number of first areas LSA of the first inorganic encapsulation layer 141 and/or the number of pattern portions HSP is increased, the organic encapsulation layer 142 may include a plurality of raised patterns PT.

When the organic encapsulation layer 142 includes a plurality of raised patterns PT, a second inorganic encapsulation layer 143 disposed on the organic encapsulation layer 142 may have a greater surface length measured in a unit area. As the length of the second inorganic encapsulation layer 143 per unit area increases, the stress applied when the display device 10 is bent can be more distributed.

A method of fabricating a display device 10 will now be described with reference to other drawings.

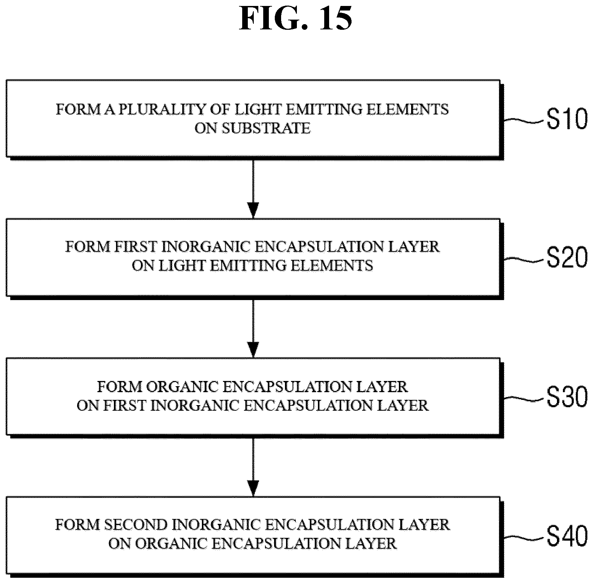

FIG. 15 is a flowchart illustrating a method of fabricating a display device according to an embodiment.

Referring to FIG. 15, the method of fabricating the display device 10 according to the embodiment may include forming a plurality of light emitting elements EL on a substrate (operation S10), forming a first inorganic encapsulation layer 141 on the light emitting elements EL (operation S20), forming an organic encapsulation layer 142 on the first inorganic encapsulation layer 141 (operation S30), and forming a second inorganic encapsulation layer 143 on the organic encapsulation layer 142 (operation S40). In the forming of the organic encapsulation layer 142 (operation S30), the amount of organic insulating material applied per unit area may be different in a flat portion FA and a bending portion EBA, and an area where a portion of the organic encapsulation layer 142 is raised may be formed in the bending portion EBA.

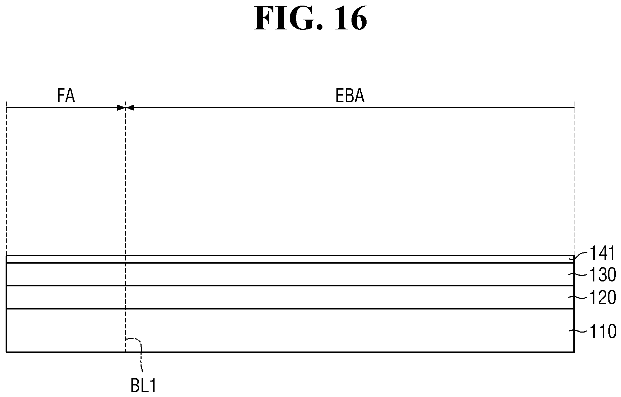

FIGS. 16 through 19 are views sequentially illustrating a process of fabricating a display device according to an embodiment.

Referring to FIG. 16, a light emitting element layer 130 is formed by forming a plurality of light emitting elements EL on a base substrate BSUB (operation S10), and a first inorganic encapsulation layer 141 is formed on the light emitting elements EL (operation S20). A pixel defining layer 131 may be formed on the base substrate BSUB, and the light emitting elements EL may be formed in openings of the pixel defining layer 131. The structures of the pixel defining layer 131 and the light emitting elements EL are the same as those described above. Each of the pixel defining layer 131 and the light emitting elements EL may be formed through a typical patterning or deposition process.

Next, the first inorganic encapsulation layer 141 is formed on the light emitting element layer 130. In an embodiment, the first inorganic encapsulation layer 141 may be formed through a plasma enhanced chemical vapor deposition (PECVD) process using a gaseous precursor or a liquid precursor. However, the disclosure is not limited thereto.

Although not illustrated in the drawings, the base substrate BSUB may include the substrate 110 and the circuit layer 120 described above. The base substrate BSUB may include a flat portion FA and a bending portion EBA, like the substrate 110.

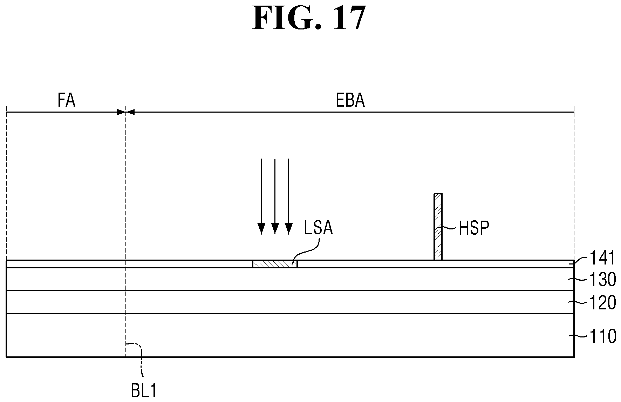

Referring to FIG. 17, a first area LSA is formed by surface-treating a portion of the first inorganic encapsulation layer 141 in the bending portion EBA. Alternatively, a pattern portion HSP is formed on the first inorganic encapsulation layer 141 in the bending portion EBA. Although both the first area LSA of the first inorganic encapsulation layer 141 and the pattern portion HSP are formed in the drawing, the disclosure is not limited thereto. In the current process, at least any one of the first area LSA of the first inorganic encapsulation layer 141 and the pattern portion HSP may be formed.

The forming of the first area LSA may include a process of treating a surface of the first inorganic encapsulation layer 141 to form an area with low surface energy. The first inorganic encapsulation layer 141 may include an inorganic insulating material. Through the surface treatment, the surface energy of the above area of the first inorganic encapsulation layer 141 may become lower than the surface energy of the surrounding area thereof. The first area LSA may induce organic insulating materials applied in a subsequent process to agglomerate with each other. Organic insulating materials applied on the first area LSA may agglomerate with each other to rise.

Unlike the first area LSA, the pattern portion HSP may include a material with high surface energy. The pattern portion HSP may be surrounded by organic insulating materials and may attract the surrounding organic insulating materials. The organic insulating materials applied on the first inorganic encapsulation layer 141 may agglomerate and rise around the pattern portion HSP.

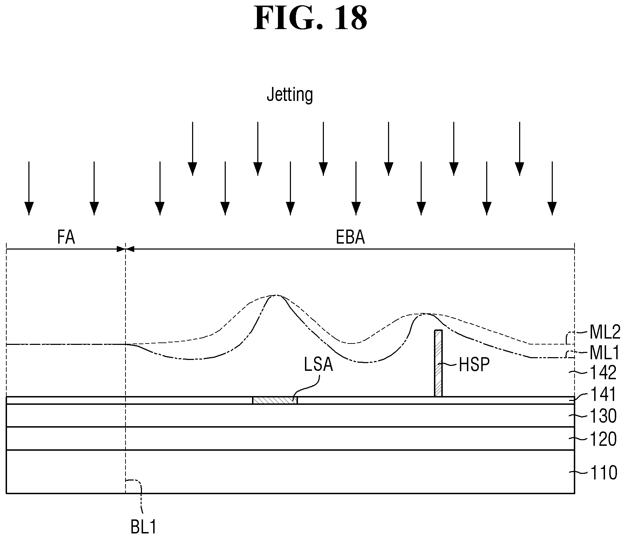

Referring to FIG. 18, an organic encapsulation layer 142 is formed by applying an organic insulating material on the first inorganic encapsulation layer 141 (operation S30). In the process of forming the organic encapsulation layer 142, the method of applying the organic insulating material is not particularly limited. In an embodiment, for example, the organic encapsulation layer 142 may be formed through chemical vapor deposition (CVD) or an inkjet printing process.

In an embodiment, in the forming of the organic encapsulation layer 142, the amount of organic insulating material applied per unit area may be larger in the bending portion EBA than in the flat portion FA. If the amount of organic insulating material applied per unit area is the same in the flat portion FA and the bending portion EBA, the organic insulating material may be evenly applied in the flat portion FA to have a uniform thickness. However, since the first area LSA of the first inorganic encapsulation layer 141 and/or the pattern portion HSP are disposed in the bending portion EBA, the organic insulating material may agglomerate around them and may not have a uniform height in the bending portion EBA. In this case, an organic layer formed by the applied organic insulating material may not have a uniform height ML1 and may form large curves in the bending portion EBA. If the organic encapsulation layer 142 is formed to have large curves, it may be too thin in areas other than the areas where the first area LSA of the first inorganic encapsulation layer 141 and/or the pattern portion HSP are disposed and thus may be unable to perform an encapsulation function.

According to an embodiment, the amount of organic insulating material applied per unit area in the process of forming the organic encapsulation layer 142 may be larger in the bending portion EBA than in the flat portion FA of the display device 10. In addition, the organic encapsulation layer 142 disposed in the bending portion EBA may have a large average height and may have raised curves in some portions (MI,2 in FIG. 18). Since the amount of organic insulating material applied per unit area is larger in the bending portion EBA than in the flat portion FA, the curves of the organic encapsulation layer 142 may not have a large step difference despite the presence of the first area LSA of the first inorganic encapsulation layer 141 and/or the pattern portion HSP. An upper surface of the organic encapsulation layer 142 may be flat in the flat portion FA and may have a partially curved shape in the bending portion EBA. A length of a second inorganic encapsulation layer 143 on the organic encapsulation layer 142 per unit area may vary.

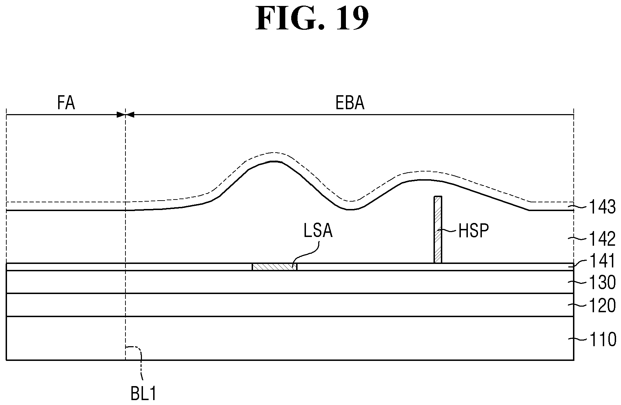

Referring to FIG. 19, the second inorganic encapsulation layer 143 is formed on the organic encapsulation layer 142 (operation S40). The second inorganic encapsulation layer 143 may be formed through the same process as the first inorganic encapsulation layer 141. In an embodiment, for example, the second inorganic encapsulation layer 143 may be formed through a PECVD process using a gaseous precursor or a liquid precursor. However, the disclosure is not limited thereto.

The second inorganic encapsulation layer 143 may be disposed on the entirety of the organic encapsulation layer 142 over the flat portion FA and the bending portion EBA. Since the organic encapsulation layer 142 is formed flat in the flat portion FA and has raised curves in some portions in the bending portion EBA, a surface length of the second inorganic encapsulation layer 143 measured in a unit area may be greater in the bending portion EBA than in the bending portion FA. Accordingly, the stress applied when the bending portion EBA of the display device 10 is bent can be smoothly distributed, and damage to the encapsulation layer 140 can be effectively prevented.

In the display device 10 including the first area LSA formed in the first inorganic encapsulation layer 141 of the encapsulation layer 140 and/or the pattern portion HSP disposed on the first inorganic encapsulation layer 141, the organic encapsulation layer 142 may have raised curves in some portions in the bending portion EBA. In addition, since the amount of organic insulating material applied per unit area in the process of forming the organic encapsulation layer 142 is larger in the bending portion EBA than in the flat portion FA, the organic encapsulation layer 142 can be prevented from becoming thinner in portions other than the raised portions of the organic encapsulation layer 142. In the display device 10, since the organic encapsulation layer 142 has curves formed in the bending portion EBA, the encapsulation layer 140 can be effectively prevented from being damaged when the display device 10 is bent. In addition, since the organic encapsulation layer 142 has curves with a small step difference in the bending portion EBA, the first inorganic encapsulation layer 141 and the second inorganic encapsulation layer 143 may not contact each other in the flat portion FA and the bending portion EBA and may be able to perform an encapsulation function for protecting the display device 10.

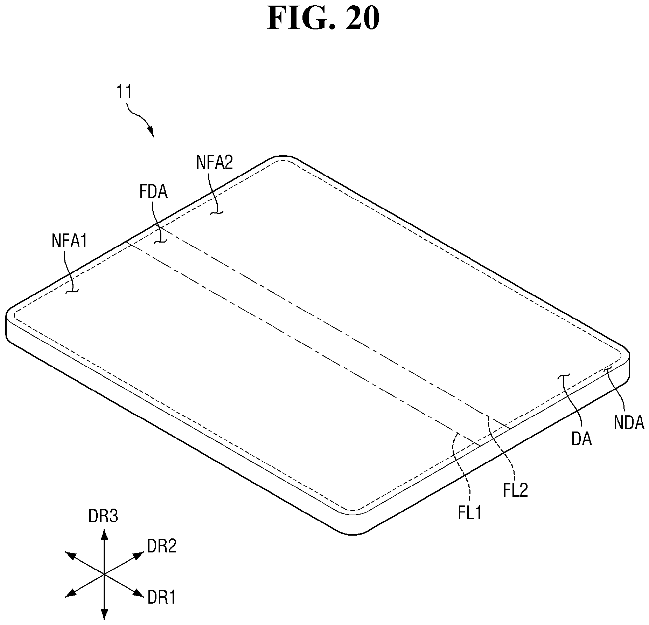

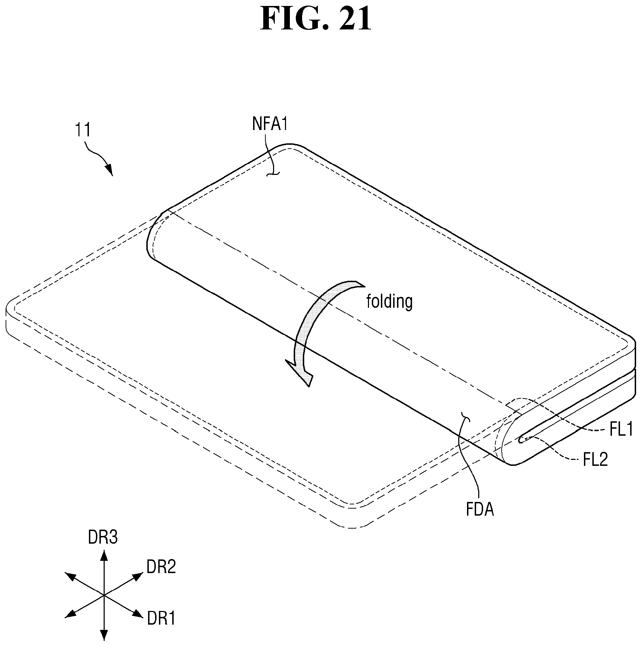

FIG. 20 is a perspective view of a foldable display device 11 according to an embodiment. FIG. 21 is a perspective view of the foldable display device 11 of FIG. 20 in a folded state. FIG. 20 illustrates the foldable display device 11 unfolded without being bent at folding lines FL1 and FL2, and FIG. 21 illustrates the foldable display device 11 bent at the folding lines FL1 and FL2.

Referring to FIGS. 20 and 21, the display device 10 according to the embodiment may be applied to the foldable display device 11. The planar shape of the foldable display device 11 may be a quadrilateral shape such as a rectangular shape. Each corner of the foldable display device 11 may have a right-angled planar shape or a round planar shape. A front surface of the foldable display device 11 may include two short sides extending in the second direction DR2 and two long sides extending in the first direction DR1.

The foldable display device 11 may include a display area DA and a non-display area NDA. The planar shape of the display area DA may follow the shape of the foldable display device 11. In an embodiment, for example, when the foldable display device 11 is rectangular in a plan view, the display area DA may also be rectangular in a plan view.

The display area DA may be an area which includes a plurality of pixels to display an image. The non-display area NDA may be an area which does not include pixels and thus does not display an image. The non-display area NDA may be disposed around the display area DA. The non-display area NDA may surround the display area DA, but embodiments of the specification are not limited thereto. The display area DA may also be partially surrounded by the non-display area NDA in another embodiment.

The foldable display device 11 may maintain both a first state which is an unfolded state as illustrated in FIG. 20 and a second state which is a folded state as illustrated in FIG. 21. The foldable display device 11 may be folded in an out-folding manner so that portions of a rear surface opposite the display area DA face each other. In this case, portions of the rear surface of the foldable display device 11 may face each other when the foldable display device 11 is folded. Alternatively, the foldable display device 11 may be folded in an in-folding manner so that portions of the front surface of the foldable display device 11 face each other.

The foldable display device 11 may include a folding area FDA, a first non-folding area NFA1, and a second non-folding area NFA2. The folding area FDA may be an area in which the foldable display device 11 is bent or folded. The first non-folding area NFA1 and the second non-folding area NFA2 may be areas in which the foldable display device 11 is not bent or folded. In an embodiment, the first non-folding area NFA1 and the second non-folding area NFA2 may be flat areas of the foldable display device 11.

The first non-folding area NFA1 may be disposed on a side, e.g., a left side of the folding area FDA. The second non-folding area NFA2 may be disposed on the other side, e.g., a right side of the folding area FDA. The folding area FDA may be an area which is defined by a first folding line FL1 and a second folding line FL2 and an area in which the foldable display device 11 is bent with a predetermined curvature. The first folding line FL1 may be a boundary between the folding area FDA and the first non-folding area NFA1, and the second folding line FL2 may be a boundary between the folding area FDA and the second non-folding area NFA2.

The first folding line FL1 and the second folding line FL2 may extend in the first direction DR1 as illustrated in FIGS. 20 and 21. In this case, the foldable display device 11 may be folded along the first direction DR1. Therefore, since a length of the foldable display device 11 in the second direction DR2 can be reduced by about half, a user can easily carry the foldable display device 11.

When the first folding line FL1 and the second folding line FL2 extend in the first direction DR1, a length of the folding area FDA in the first direction DR1 may be greater than a length of the folding area FDA in the second direction DR2. In addition, a length of the first non-folding area NFA1 in the first direction DR1 may be greater than a length of the first non-folding area NFA1 in the second direction DR2. A length of the second non-folding area NFA2 in the first direction DR1 may be greater than a length of the second non-folding area NFA2 in the second direction DR2.

Each of the display area DA and the non-display area NDA may overlap at least one of the folding area FDA, the first non-folding area NFA1, and the second non-folding area NFA2 in a normal direction of the substrate 110. In FIGS. 20 and 21, each of the display area DA and the non-display area NDA overlaps the folding area FDA, the first non-folding area NFA1, and the second non-folding area NFA2 in a normal direction of the substrate 110.

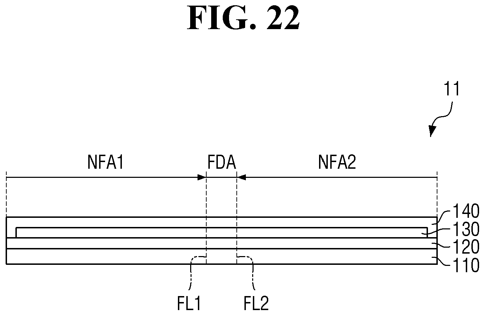

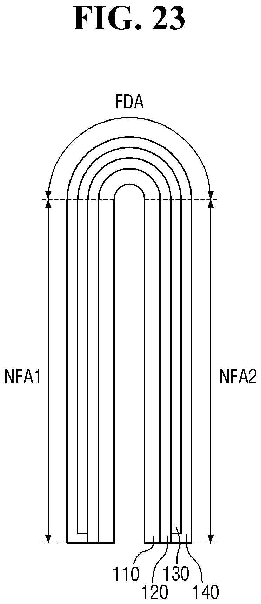

FIG. 22 is a schematic cross-sectional view of the foldable display device 11 according to the embodiment of FIG. 20. FIG. 23 is a cross-sectional view of the foldable display device 11 of FIG. 22 in a folded state.

Referring to FIGS. 22 and 23, the foldable display device 11 may include a substrate 110 including the folding area FDA and the non-folding areas NFA1 and NFA2 and a circuit layer 120, a light emitting element layer 130 and an encapsulation layer 140 sequentially disposed on the substrate 110. These elements may be similar to those described above with reference to FIGS. 1 through 9.

The folding area FDA of the foldable display device 11 may be folded with respect to the folding lines FL1 and FL2. As the folding area FDA is folded, the non-folding areas NFA1 and NFA2 may be moved downward, i.e., toward one side in the third direction DR3, and the folding area FDA may become convex upward. Accordingly, rear surfaces of the first non-folding area NFA1 and the second non-folding area NFA2 may face each other.

When the foldable display device 11 is folded in the folding area FDA, stress due to the folding may be applied to a portion of the encapsulation layer 140 which is located in the folding area FDA. As described above, the organic encapsulation layer 142 of the encapsulation layer 140 may have different cross-sectional shapes in the folding area FDA and the non-folding areas NFA1 and NFA2 and may well distribute the stress generated during the folding.

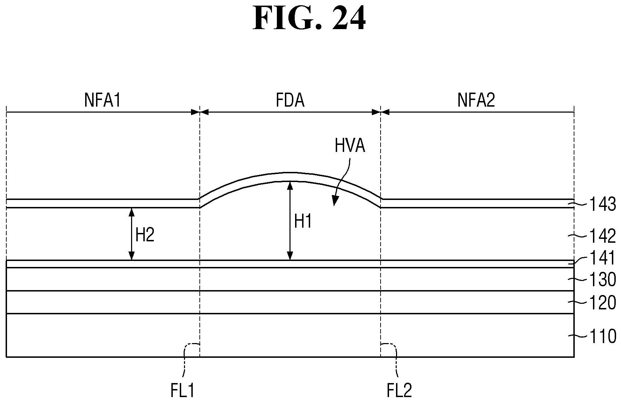

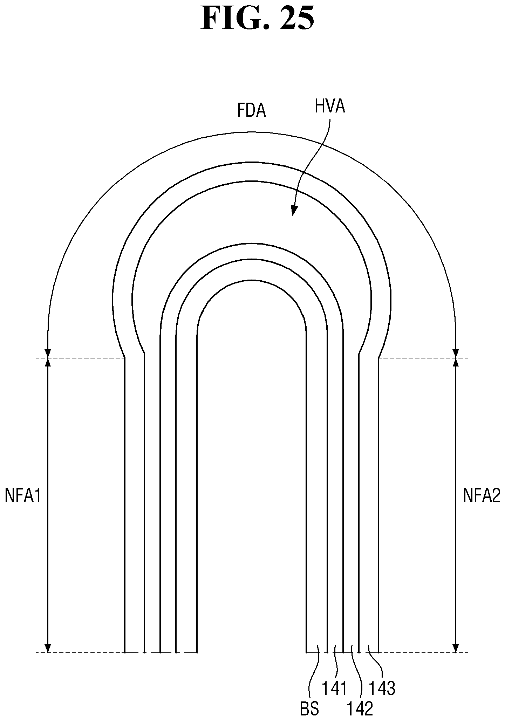

FIG. 24 is a cross-sectional view of the encapsulation layer 140 of the foldable display device 11 of FIG. 22 in a flat state. FIG. 25 is a cross-sectional view of the encapsulation layer 140 of the foldable display device 11 of FIG. 24 in a folded state.

Referring to FIGS. 24 and 25, in the foldable display device 11 according to the embodiment, the volume or amount of organic insulating material per unit area in the organic encapsulation layer 142 of the encapsulation layer 140 may be larger in the folding region FDA than in the non-folding areas NFA1 and NFA2. A portion of the organic encapsulation layer 142 in the folding area FDA may have a greater height than the organic encapsulation layer 142 in the non-folding areas NFA1 and NFA2. The organic encapsulation layer 142 may have an upwardly protruding portion in the folding area FDA, and the protruding portion may form an area HVA in which the volume of the organic insulating material per unit area is larger than in the non-folding areas NFA1 and NFA2. A maximum height H1 of the organic encapsulation layer 142 of the foldable display device 11 measured in the folding area FDA may be greater than a maximum height H2 measured in the non-folding areas NFA1 and NFA2.

In addition, the foldable display device 11 may have a structure in which a second inorganic encapsulation layer 143 is longer in the folding area FDA than in the non-folding areas NFA1 and NFA2 when measured in a unit area. A surface length L1 of the second inorganic encapsulation layer 143 measured in a unit area of the folding area FDA may be greater than a surface length L2 measured in a unit area of each of the non-folding areas NFA1 and NFA2. When the foldable display device 11 is folded, the area HVA having a large volume per unit area in the organic encapsulation layer 142 can offset a thinning portion in the folding area FDA. In addition, when the second inorganic encapsulation layer 143 is bent, it can be effectively prevented from being damaged by stress.

In a display device according to an embodiment, an organic encapsulation layer of an encapsulation layer may have a larger amount of organic material applied in a bending or folding area. Therefore, stress generated during bending or folding can be distributed.

In a display device according to an embodiment, an encapsulation layer can be prevented from being damaged when bent or folded.

In concluding the detailed description, those skilled in the art will appreciate that many variations and modifications can be made to the preferred embodiments without substantially departing from the principles of the invention. Therefore, the disclosed preferred embodiments of the invention are used in a generic and descriptive sense only and not for purposes of limitation.

## Claims

1. A display device comprising:
a substrate comprising a flat portion and a bending portion disposed on a side of the flat portion;
a light emitting element layer disposed on the substrate and comprising a plurality of light emitting elements disposed in the flat portion and the bending portion; and
an encapsulation layer disposed over the flat portion and the bending portion and comprising a first inorganic encapsulation layer disposed on the light emitting element layer, an organic encapsulation layer disposed on the first inorganic encapsulation layer, and a second inorganic encapsulation layer disposed on the organic encapsulation layer,
wherein at least a portion of the organic encapsulation layer disposed in the bending portion comprises a portion protruding in a direction upward from the substrate, and a maximum height of the organic encapsulation layer disposed in the bending portion is greater than a maximum height of the organic encapsulation layer disposed in the flat portion.

2. The display device of claim 1, wherein an average height of the organic encapsulation layer disposed in the bending portion is greater than an average height of the organic encapsulation layer disposed in the flat portion.

3. The display device of claim 1 or claim 2, wherein the organic encapsulation layer comprises an organic insulating material, and a volume of the organic insulating material per unit area of the protruding portion of the bending portion is larger than a volume of the organic insulating material per unit area of the flat portion.

4. The display device of any one of claims 1 to 3, wherein a surface length of the second inorganic encapsulation layer measured in a unit area of the bending portion is greater than a surface length of the second inorganic encapsulation layer measured in a unit area of the flat portion.

5. The display device of any one of claims 1 to 4, wherein the first inorganic encapsulation layer comprises a first area and a second area other than the first area in the bending portion, the first area has lower surface energy than the second area, and a height of the organic encapsulation layer disposed in the first area is greater than a height of the organic encapsulation layer disposed in the second area.

6. The display device of any one of claims 1 to 5, further comprising a pattern portion disposed on the first inorganic encapsulation layer in the bending portion and comprising a material having higher surface energy than a material surrounding the pattern portion, wherein the organic encapsulation layer has a greater height in a portion overlapping the pattern portion than in other areas of the bending portion.

7. The display device of any one of claims 1 to 6, wherein the protruding portion is provided in plurality in the organic encapsulation layer disposed in the bending portion.

8. The display device of any one of claims 1 to 7, wherein the bending portion is bendable toward a rear surface of the substrate opposite a surface of the substrate on which the light emitting element layer is disposed.

9. The display device of claim 8, wherein the bending portion comprises a first bending portion disposed on a side of the flat portion in a first direction and a second bending portion disposed on another side of the flat portion in a direction opposite to the first direction, and the first bending portion, the second bending portion and the flat portion have a same length measured in a second direction, optionally wherein the protruding portion of the organic encapsulation layer is disposed to correspond to a curved area of the bending portion.

10. A display device comprising:
a substrate comprising a folding area folded along a folding line extending in a first direction and a non-folding area disposed around the folding area;
a light emitting element layer disposed on the substrate and comprising a plurality of light emitting elements disposed in the folding area and the non-folding area; and
an encapsulation layer disposed over the folding area and the non-folding area and comprising a first inorganic encapsulation layer disposed on the light emitting element layer, an organic encapsulation layer disposed on the first inorganic encapsulation layer and comprising an organic insulating material, and a second inorganic encapsulation layer disposed on the organic encapsulation layer,
wherein at least a portion of the organic encapsulation layer disposed in the folding area comprises a portion protruding in a direction upward from the substrate, and a volume of the organic insulating material of the organic encapsulation layer per unit area of the folding area is larger than a volume of the organic insulating material per unit area of the non-folding area.

11. The display device of claim 10, wherein a surface length of the second inorganic encapsulation layer measured in a unit area of the folding area is greater than a surface length of the second inorganic encapsulation layer measured in a unit area of the non-folding area, optionally wherein a maximum height of the organic encapsulation layer disposed in the folding area is greater than a maximum height of the organic encapsulation layer disposed in the non-folding area.

12. A method of fabricating a display device, the method comprising:
forming a light emitting element layer, which comprises a plurality of light emitting elements, on a substrate comprising a flat portion and a bending portion disposed on a side of the flat portion;
forming a first inorganic encapsulation layer on the light emitting element layer and forming an organic encapsulation layer by applying an organic insulating material on the first inorganic encapsulation layer; and
forming a second inorganic encapsulation layer on the organic encapsulation layer,
wherein in the forming of the organic encapsulation layer, an amount of the organic insulating material applied per unit area of the bending portion is larger than an amount of the organic insulating material applied per unit area of the flat portion.

13. The method of claim 12, further comprising, before the forming of the organic encapsulation layer, forming a first area with lower surface energy than an adjacent area by surface-treating a portion of the first inorganic encapsulation layer disposed in the bending portion.

14. The method of claim 12 or claim 13, further comprising, after the forming of the first inorganic encapsulation layer, forming a pattern portion disposed on the first inorganic encapsulation layer in the bending portion and comprising a material with higher surface energy than the organic insulating material surrounding thereof, optionally wherein in the applying of the organic insulating material, the organic insulating material agglomerates around the pattern portion, and a portion of the organic encapsulation layer which overlaps the pattern portion has a greater height than other portions.

15. The method of any one of claims 12 to 14, wherein:
(i) the organic encapsulation layer comprises an organic insulating material, and a volume of the organic insulating material per unit area of the bending portion is larger than a volume of the organic insulating material per unit area of the flat portion; and/or
(ii) a maximum height of the organic encapsulation layer disposed in the bending portion is greater than a maximum height of the organic encapsulation layer disposed in the flat portion; and/or
(iii) a surface length of the second inorganic encapsulation layer measured in a unit area of the bending portion is greater than a surface length of the second inorganic encapsulation layer measured in a unit area of the flat portion.
